# EUROPÄISCHE PATENTSCHRIFT

(11) **EP 2 870 620 B1**
(45) Veröffentlichungstag und Bekanntmachung des Hinweises auf die Patenterteilung: **07.12.2016**
(21) Anmeldenummer: 13736485.7
(22) Anmeldetag: 08.07.2013
(51) Int. Cl.: H01L 31/036

(54) **WAFER UND VERFAHREN ZUR HERSTELLUNG VON WAFERN MIT OBERFLÄCHENSTRUKTUREN**
WAFER AND METHOD FOR PRODUCING WAFERS HAVING SURFACE STRUCTURES
PLAQUETTE ET PROCÉDÉ DE FABRICATION DE PLAQUETTES MUNIES DE STRUCTURES DE SURFACE

(30) Priorität: 06.07.2012 DE 102012013539
(43) Veröffentlichungstag der Anmeldung: 13.05.2015
(73) Patentinhaber: Siltectra GmbH, 01099 Dresden (DE)
(72) Erfinder: LICHTENSTEIGER, Lukas, CH-8037 Zürich (CH); AJAJ, Anas, 01069 Dresden (DE); RICHTER, Jan, 01277 Dresden (DE)
(74) Vertreter: Ascherl, Andreas
(86) Internationale Anmeldenummer: PCT/EP2013/002009
(87) Internationale Veröffentlichungsnummer: WO 2014/005726

(56) Entgegenhaltungen:
- EP-A2- 1 858 087
- WO-A2-2009/061353
- STEPHEN W BEDELL ET AL: "Kerf-Less Removal of Si, Ge, and III V Layers by Controlled Spalling to Enable Low-Cost PV Technologies", IEEE JOURNAL OF PHOTOVOLTAICS, I E E E, US, Bd. 2, Nr. 2, 1. April 2012 (2012-04-01), Seiten 141-147, XP011434299, ISSN: 2156-3381, DOI: 10.1109/JPHOTOV.2012.2184267

## Beschreibung

Die vorliegende Erfindung betrifft Wafer und ein Verfahren zur Herstellung von Wafern mit Oberflächenstrukturen, insbesondere zur Herstellung von dünnen Wafern aus Werkstoffen geringer Duktilität mittels temperaturinduzierter mechanischer Spannung unter Verwendung von vorgefertigten Polymer-Folien.

In vielen technischen Bereichen (z.B. Mikroelektronik- oder Photovoltaiktechnologie) werden Materialien wie z.B. Silizium, Germanium oder Saphir häufig in der Form dünner Scheiben und Platten (so genannte Wafer) gebraucht. Standardmässig werden solche Wafer derzeit durch Sägen aus einem Ingot hergestellt, wobei relativ grosse Materialverluste ("kerf-loss") entstehen. Da das verwendete Ausgangsmaterial oft sehr teuer ist, gibt es starke Bestrebungen, solche Wafers mit weniger Materialaufwand und damit effizienter und kostengünstiger herzustellen.

Beispielsweise gehen mit den derzeit üblichen Verfahren allein bei der Herstellung von Siliziumwafer für Solarzellen fast 50% des eingesetzten Materials als "kerf-loss" verloren. Weltweit gesehen entspricht dies einem jährlichen Verlust von über 2 Milliarden Euro. Da die Kosten des Wafers den grössten Anteil an den Kosten der fertigen Solarzelle ausmachen (über 40%), könnten durch entsprechende Verbesserungen der Waferherstellung die Kosten von Solarzellen signifikant reduziert werden.

Besonders attraktiv für eine solche Waferherstellung ohne kerf-loss ("kerf-free wafering") erscheinen Verfahren, die auf das herkömmliche Sägen verzichten und z.B. durch Einsatz von temperaturinduzierten Spannungen direkt dünne Wafer von einem dickeren Werkstück abspalten können. Dazu gehören insbesondere Verfahren, wie sie z.B. in PCT/US2008/012140 und PCT/EP2009/067539 beschrieben sind, wo zum Erzeugen dieser Spannungen eine auf das Werkstück aufgetragene Polymerschicht verwendet wird.

Diese Polymerschicht wird nach aktuellem Stand der Technik in flüssiger Form in einem Gießverfahren auf das zu bearbeitende Werkstück aufgetragen und dann dort ausgehärtet. Dabei wird beim Auftragen genau so viel Masse aufgebracht, dass die Oberflächenspannung den Polymer-Film auf dem Werkstück hält. Diese Methode führt zu einem nicht genügend definierbaren Randabschluss von Werkstück und Polymerschicht. Insbesondere kann am Rand der Polymerschicht keine exakt senkrecht zur Oberfläche des Werkstücks stehende Kante erzielt werden. Dadurch kann es am Rand der Polymerschicht dazu kommen, dass einerseits die Schicht lokal zu dünn wird und dass durch die Oberflächengeometrie der Krafteintrag beim Erzeugen von temperaturinduzierten Spannungen relativ undefiniert geschieht. Beide Probleme führen zu unkontrollierbar rauen Oberflächen im Randbereich der produzierten Wafer.

Ausserdem wird beim bisherigen Giessverfahren relativ viel Zeit sowie eine stets exakt horizontale Ausrichtung der zu bearbeitenden Oberfläche des Werkstücks benötigt, um die gleichmässige Verteilung des Polymers durch Zerlaufen sicherzustellen. Zudem müssen ev. im flüssigen Polymer vorhandene Luftblasen einzeln beseitigt werden, was relativ zeitaufwändig ist.

Schliesslich ist beim bisherigen Verfahren die Dicke des Polymerfilms begrenzt, weil ab einer bestimmten Schichtdicke die Oberflächenspannung nicht mehr ausreicht, um den Film auf dem Werkstück zu halten und deshalb das Polymer über den Rand des Werkstücks hinausläuft. Mit der vorliegenden Erfindung - dem Aufbringen von vorfabrizierten Polymerfolien - werden alle diese Probleme und Einschränkungen behoben. Als Werkstück wird dabei vorzugsweise ein dickerer Wafer verwendet, von welchem dann unter Verwendung des beschriebenen Verfahrens ein oder mehrere, dünnere Wafer abgespaltet werden.

Ferner besteht ein Bedarf Wafer mit Oberflächenstrukturen zu erzeugen, um den Wafer hinsichtlich des gewünschten Anwendungsfalls mit einer entsprechenden Oberfläche zu versehen.

Es ist somit Aufgabe der vorliegenden Erfindung, einen Wafer und ein entsprechendes Verfahren zur Herstellung von Wafern mit Oberflächenstrukturen breitzustellen, wobei einerseits die Herstellungskosten vermindert werden und andererseits der Wafer hinsichtlich des gewünschten Anwendungsfalls mit einer entsprechenden Oberfläche versehen werden kann.

Diese Aufgabe wird durch die Merkmale von Anspruch 1 gelöst. Es ist besonders vorteilhaft, wenn die Kompositstruktur mit einem inneren und/oder äußeren Spannungsfeld in der Art beaufschlagt wird, so dass das Ausgangsmaterial (4) entlang einer inneren Ebene unter Bildung des Wafers gespalten wird, wobei der Wafer reliefartige 3-dimensionale Oberflächenstrukturen an der sich ergebenden Spaltfläche aufweist, welche durch die Eigenschaften des Ausgangsmaterials vorbestimmbar sind und dadurch ein Wafer mit einer nach Bedarf anpassbaren Oberfläche herstellbar ist.

So können in kostengünstiger Art Wafer mit einer gewünschten Oberfläche, insbesondere mit einer vergrößerten Oberfläche hergestellt werden, um beispielsweise die aktive Fläche einer vorgegebenen Solarzelle zu erhöhen. Ferner können Wafer mit einer gewünschten bzw. vorbestimmbaren Oberflächenstrukturierung in Abhängigkeit des Anwendungsfalles des Wafers erzeugt werden.

Insbesondere weist der erfindungsgemäße Wafer als Ausgangsmaterials (4) einen Werkstoff mit geringer Duktilität auf, welches zumindest eine exponierte Oberfläche aufweist, wobei mindestens eine vorgefertigte Aufbringungsschicht (1), welche frei wählbare Materialeigenschaften aufweist, an der exponierten Oberfläche des Ausgangsmaterials (4) unter Bildung einer Kompositstruktur aufgebracht wird, wobei die Kompositstruktur mit einem inneren und/oder äußeren Spannungsfeld in der Art beaufschlagt wird, so dass das Ausgangsmaterial (4) entlang einer inneren Ebene unter Bildung des Wafers gespalten wird, wobei der Wafer reliefartige Oberflächenstrukturen an der sich ergebenden Spaltfläche mit im wesentlichen vorbestimmbaren Mustern aufweist, welche durch die Eigenschaften des Ausgangsmaterials variierbar sind.

Vorzugsweise weist der Wafer Oberflächenstrukturen an der Spaltfläche auf, welche durch die exponierte Oberfläche und/oder die Randgeometrie des Ausgangsmaterials derart beeinflussbar sind, dass die Oberfläche an der Spaltfläche komplementär zur exponierten Oberfläche und/oder komplementär zur Randgeometrie des Ausgangsmaterials ist, und wobei die Oberflächenstrukturen an der sich ergebenden Spaltfläche im wesentlichen vorbestimmbare Muster in Form von offenen und geschlossenen Wallnerlinien aufweisen, und wobei die geschlossenen Wallnerlinien im wesentlichen der Randgeometrie des Ausgangsmaterials entsprechen.

Weitere vorteilhafte Ausgestaltungen der Erfindung sind Gegenstand der Unteransprüche.

Im folgenden wird das Verfahren zur Herstellung eines erfindungsgemäßen Wafers näher erläutert. Vorgefertigte (d.h., nicht direkt auf dem Werkstück verfestigte) Polymerfolien können so gefertigt werden (z.B. mittels Zuschneiden, Stanzen, Giessen in Schalungen), dass ein viel genauer definierbarer Randabschluss von Werkstück und Polymerschicht erreicht wird.

Polymerfolien lassen sich vorfertigen, qualifizieren und getrennt vom Werkstück herstellen, so dass die Fertigung und Qualifikation der Polymerschicht unabhängig von der Waferfertigung geschehen kann. Mit anderen Worten: die Eigenschaften der Polymerschicht können somit unabhängig von anderen Prozessschritten definiert und kontrolliert werden.

Die getrennte Fertigung von Folie und Wafer hat beispielsweise den Vorteil, dass die Parameter zum Härten der Polymerschicht, wie z.B. Härtetemperatur und -zeit, sehr frei wählbar sind. So können z.B. bei der Verwendung von zwei Polymerschichten auf demselben Werkstück die beiden Schichten unabhängig voneinander gehärtet werden, was bei der bisherigen Methode nicht möglich ist. Ausserdem führt das Härten direkt auf dem Werkstück mit der bisherigen Methode bei Härtetemperaturen über Raumtemperatur automatisch zu einer Vorspannung des Films bei Raumtemperatur. Diese Vorspannung kann nach dem Abspalten zu starkem Durchbiegen und Zerbrechen der produzierten Wafer führen. Die Verwendung einer vorgefertigten Folie macht es möglich, die Aushärtetemperatur der Folie frei zu wählen ohne Auswirkungen auf eine,eventuelle Vorspannung.

Zudem kann mit Hilfe der Erfindung auch die Stärke der Polymerschicht beliebig gewählt und genau eingestellt werden (wir verwenden üblicherweise Dicken zwischen ca. 0.1 und 10mm, vorzugsweise zwischen 0.4 und 1mm, wobei zur Herstellung dickerer Wafer dickere Polymerschichten verwendet werden). Speziell können beispielsweise auch strukturierte Folien verwendet werden, wo z.B. die Foliendicke je nach Position gezielt variiert wird, so dass Folienschichten mit definierten Dickenprofilen möglich sind.

Als Polymer kann z.B. ein Polydiorgaholsiloxan verwendet werden, z.B. Polydimethylsiloxane (PDMS). Im folgenden wird als Polymerfolie eine Folie aus PDMS und als Werkstück ein dicker Wafer aus Silizium beschrieben; es können aber auch andere geeignete Polymere und Werkstücke (z.B. aus anderen Materialien wie Germanium, Saphir, etc) verwendet werden.

Zur Herstellung der Polymerfolien verwenden wir PDMS Sylgard 184 von Dow Corning. Dies ist ein zweikomponentiges Gemisch, das thermisch ausgehärtet wird (wir verwenden dazu z.B. Mischverhältnisse zwischen Härter:Basismaterial von 1:10 bis 1:3). Zum Härten verwenden wir - je nach Härtezeit - Temperaturen von Raumtemperatur bis ca. 200°C, vorzugsweise von ca. 60°C bis 150°C. Wir verwenden üblicherweise Härtezeiten zwischen ca. 1-20 Minuten (bei hohen Temperaturen) und 1-2 Tage (bei Raumtemperatur). Bei PDMS Sylgard 184 handelt es sich vor dem Härten um eine viskose Flüssigkeit, die z.B. mittels Giessverfahren auf eine glatte Oberfläche (z.B. Spiegel) aufgebracht wird und dort zu einer Folie aushärtet. Die Folie wird von dieser Oberfläche dann abgezogen (z.B. mechanisch), gegebenenfalls weiterverarbeitet, und danach auf das Werkstück aufgebracht. Ausserdem kann die fertige Folie bereits vor dem Aufbringen auf das Werkstück untersucht und ihre Qualität überprüft werden (z.B. mit üblichen mechanischen, optischen oder elektrischen Messverfahren, etc). Neben dem hier beschriebenen Verfahren zur Folienherstellung sind viele andere Verfahren in der Industrie üblich (z.B. Herstellung durch Extrusion), welche ebenfalls für die vorliegende Erfindung anwendbar sind.

Die fertige Folie wird danach auf die Oberfläche des Werkstücks (z.B. dicker Wafer) aufgebracht. Dabei ist eine gute Haftung der Folie auf dem Werkstück wichtig: die Verbindung zwischen Werkstück und Folie muss genügend grosse Scherkräfte für das Abspalten sowie grosse Temperaturschwankungen für das thermische Induzieren der nötigen Spannungen aushalten können.

Für das Aufkleben der Folie bietet sich ein dünner PDMS-Film als Kleber an (z.B. ebenfalls unter Verwendung von Sylgard 184). Dieser wird z.B. mit einer Spritze in der Mitte der zu beklebenden Oberfläche auf dem Werkstück aufgetragen (einige Milliliter für einen 5-inch Wafer). Danach wird die Folie aufgelegt und mit einer Rolle oder Walze unter leichtem Druck auf das Werkstück gepresst. Durch Hin- und Herbewegen der Rolle verteilt sich der Kleberfilm unter der Folie, Luftblasen werden entfernt. Die Aushärtung des Klebers kann bei Raumtemperatur erfolgen. Für die Vermeidung von Zugspannungen nach dem Split (siehe Foto) empfiehlt sich eine Klerberhärtetemperatur von unter 60°C. Für ein einfacheres Verteilen des Kleberfilms mit der Rolle ist eine geringere Viskosität des Klebers vorteilhaft, was z.B. einfach durch einen grösseren Anteil an Härtersubstanz (z.B. 1:3 Härter:Basismaterial) erreicht werden kann. Die Härtezeiten variieren wie bei der Folienherstellung abhängig von der Härtetemperatur (siehe oben).

Alternativ zur beschriebenen Methode kann die Folie auch mit anderen üblichen Verfahren auf das Werkstück aufgeklebt werden, z.B. unter Verwendung eines Vakuum-Laminators. Schliesslich kann die Folie auch direkt (ohne Kleber) mit der Oberfläche des Werkstücks verbunden werden, z.B. mittels "Plasma activated bonding" (z.B. Aktivierung der PDMS-Folie in Stickstoffplasma, Aufpressen der Folie auf Werkstück, ggf. "Annealing") oder z.B. durch Auflaminieren (Aufschmelzen) einer thermoplastischen Folie (z.B. Geniomer von Wacker Silicones).

Nachdem die Folie aufgeklebt und der Kleber ausgehärtet ist, wird wie in den im Stand der Technik beschriebenen Referenzen üblich z.B. durch thermisch induzierte Spannungen ein dünner Wafer vom Werkstück abgelöst, wobei die Folie noch auf einer Seite des Wafers anhaftet. Die Folie kann dann vom hergestellten Wafer z.B. mit mechanischen oder chemischen Methoden abgelöst werden, wie in den erwähnten Referenzen dargestellt.

Um das Ablösen der Folie nach dem Abspalten des Wafers zu erleichtern, kann das Werkstück vor dem Aufkleben der Folie mit einer dünnen Opferschicht beschichtet werden. Die Folie wird dann nicht direkt auf die Oberfläche des Werkstücks, sondern auf die Opferschicht aufgeklebt. Nach dem Abspalten des Wafers kann die zwischen Werkstückoberfläche und Folie befindliche Opferschicht z.B. chemisch aufgelöst werden, wodurch sich die Folie vom hergestellten Wafer ablöst. Als Opferschicht eignet sich ein Material, welches im ganzen Temperaturbereich von ca. -200°C bis Raumtemperatur grosse Kräfte übertragen kann und dabei sowohl auf dem Werkstück wie auch auf der Folie gut haftet, und welches ausserdem einfach (z.B. chemisch) aufgelöst werden kann. Auch bei Verwendung der bisherigen Methode mit Aufgiessen des Polymers und Aushärten direkt auf dem Werkstück oder bei Verwendung von "Plasma activated bonding" kann die Verwendung einer solchen Opferschicht zwischen Polymer und Werkstück das Ablösen des Polymerfilms vom abgespalteten Wafer deutlich verbessern.

Ausserdem ist es möglich, die Funktionen von Opferschicht und Kleber zu kombinieren, d.h., zum Aufkleben der Folie einen Kleber zu verwenden, der einfach wieder aufgelöst werden kann (z.B. chemisch, oder durch Aufschmelzen, etc).

Nachdem die Folie vom hergestellten Wafer abgelöst ist, kann sie - falls gewünscht - gereinigt und danach auf ein neues Werkstück aufgebracht werden. Dadurch ist es möglich, dieselbe Folie mehrfach zur Herstellung von Wafer zu verwenden. Dies kann den Materialverbrauch und die Kosten des Gesamtprozesses signifikant reduzieren. Für eine Wiederverwendung der Folie ist es insbesondere vorteilhaft, wie oben beschrieben einen wieder auflösbaren Kleber zu verwenden, da in diesem Fall nach dem Auflösen der Kleberschicht an der Folie keine Kleberrückstände mehr verbleiben.

Anhand der nachfolgenden Zeichnungen werden beispielhaft vorteilhafte Ausgestaltungen der Erfindung dargestellt.
Figur 1 zeigt eine schematische Darstellung des erfindungsgemäßen Verfahrens zur Herstellung eines Wafers im Dünnschichtverfahren durch thermische Spaltung.
Figur 2 zeigt einen erfindungsgemäßen Wafer mit Oberflächenstrukturen, welcher gemäß dem erfindungsgemäßen Verfahren aus einem im wesentlichen rechteckigen Ausgangsmaterial hergestellt ist.
Figur 3 zeigt erfindungsgemäße Wafer mit Oberflächenstrukturen, welche gemäß dem erfindungsgemäßen Verfahren aus einem im wesentlichen runden Ausgangsmaterial hergestellt sind.
Figur 3a zeigt einen erfindungsgemäßen Wafer mit Oberflächenstrukturen, welcher gemäß dem erfindungsgemäßen Verfanren aus einem im wesentlichen runden Ausgangsmaterial hergestellt ist.
Figur 3b zeigt einen erfindungsgemäßen Wafer mit Oberflächenstrukturen, welcher gemäß dem erfindungsgemäßen Verfahren aus einem im wesentlichen runden Ausgangsmaterial hergestellt ist.
Figur 4 zeigt erfindungsgemäße Wafer mit Oberflächenstrukturen, welche gemäß dem erfindungsgemäßen Verfahren aus einem im wesentlichen rechteckigen Ausgangsmaterial hergestellt sind.
Figur 4a zeigt einen erfindungsgemäßen Wafer mit Oberflächenstrukturen, welcher gemäß dem erfindungsgemäßen Verfahren aus einem im wesentlichen rechteckigen Ausgangsmaterial hergestellt ist.
Figur 4b zeigt einen erfindungsgemäßen Wafer mit Oberflächenstrukturen, welcher gemäß dem erfindungsgemäßen Verfahren aus einem im wesentlichen rechteckigen Ausgangsmaterial hergestellt ist.
Figur 5 zeigt erfindungsgemäße Wafer mit Oberflächenstrukturen, welche gemäß dem erfindungsgemäßen Verfahren aus einem im wesentlichen rechteckigen Ausgangsmaterial hergestellt sind.
Figur 5a zeigt einen erfindungsgemäßen Wafer mit Oberflächenstrukturen, welcher gemäß dem erfindungsgemäßen Verfahren aus einem im wesentlichen rechteckigen Ausgangsmaterial hergestellt ist.
Figur 5b zeigt einen erfindungsgemäßen Wafer mit Oberflächenstrukturen, welcher gemäß dem erfindungsgemäßen Verfahren aus einem im wesentlichen rechteckigen Ausgangsmaterial hergestellt ist.
Figur 6 zeigt einen erfindungsgemäßen Wafer mit Oberflächenstrukturen, welcher gemäß dem erfindungsgemäßen Verfahren hergestellt ist.
Figur 6a zeigt einen erfindungsgemäßen Wafer mit Oberflächenstrukturen, welcher gemäß dem erfindungsgemäßen Verfahren aus einem im wesentlichen rechteckigen Ausgangsmaterial hergestellt ist.
Figur 7a zeigt einen erfindungsgemäßen Wafer mit Oberflächenstrukturen, welcher gemäß dem erfindungsgemäßen Verfahren hergestellt ist.
Figur 7b zeigt einen erfindungsgemäßen Wafer mit Oberflächenstrukturen, welcher gemäß dem erfindungsgemäßen Verfahren hergestellt ist.
Figur 8 zeigt einen erfindungsgemäßen Wafer mit Oberflächenstrukturen, welcher gemäß dem erfindungsgemäßen Verfahren hergestellt ist, wobei die Oberfläche im wesentlichen glatt ist.
Figur 9 zeigt einen erfindungsgemäßen Wafer mit Oberflächenstrukturen, welcher gemäß dem erfindungsgemäßen Verfahren hergestellt ist, wobei die Oberfläche im wesentlichen rauh ist.
Figur 10 zeigt einen erfindungsgemäßen Wafer mit Oberflächenstrukturen, welcher gemäß dem erfindungsgemäßen Verfahren hergestellt ist, wobei die Oberfläche im wesentlichen mittel-rauh ist.
Figur 11 zeigt einen erfindungsgemäßen Wafer mit Oberflächenstrukturen, welcher gemäß dem erfindungsgemäßen Verfahren hergestellt ist, wobei die Oberfläche im wesentlichen rauh ist.
Figur 12 zeigt einen erfindungsgemäßen Wafer mit Oberflächenstrukturen, welcher gemäß dem erfindungsgemäßen Verfahren hergestellt ist.
Figur 13 zeigt einen erfindungsgemäßen Wafer mit Oberflächenstrukturen, welcher gemäß dem erfindungsgemäßen Verfahren hergestellt ist.
Figur 14 zeigt einen erfindungsgemäßen Wafer mit Oberflächenstrukturen, welcher gemäß dem erfindungsgemäßen Verfahren hergestellt ist.
Figur 15 zeigt einen erfindungsgemäßen Wafer mit Oberflächenstrukturen, welcher gemäß dem erfindungsgemäßen Verfahren hergestellt ist.
Figur 16 zeigt einen erfindungsgemäßen Wafer mit Oberflächenstrukturen, welcher gemäß dem erfindungsgemäßen Verfahren hergestellt ist.
Figur 17 zeigt einen erfindungsgemäßen Wafer mit Oberflächenstrukturen, welcher gemäß dem erfindungsgemäßen Verfahren hergestellt ist.
Figur 18 zeigt einen erfindungsgemäßen Wafer mit Oberflächenstrukturen, welcher gemäß dem erfindungsgemäßen Verfahren hergestellt ist.
Figur 19 zeigt einen erfindungsgemäßen Wafer mit Oberflächenstrukturen, welcher gemäß dem erfindungsgemäßen Verfahren hergestellt ist.
Figur 20 zeigt einen erfindungsgemäßen Wafer mit Oberflächenstrukturen, welcher gemäß dem erfindungsgemäßen Verfahren hergestellt ist.
Figur 21 zeigt eine Statistik der Splitdicken bei Si-Wafern
Figur 22 zeigt einen erfindungsgemäßen Wafer mit Oberflächenstrukturen, in diesem Fall ein quadratischer Wafer, welcher gemäß dem erfindungsgemäßen Verfahren hergestellt ist.
Figur 22a zeigt einen erfindungsgemäßen Wafer aus Silizium mit Oberflächenstrukturen, welcher gemäß dem erfindungsgemäßen verfahren hergestellt ist. Die Oberfläche ist rauh. Die Maße betragen ca. 1,5x1,5 cm. Die Dicke beträgt 100µm.
Figur 22b zeigt einen erfindungsgemäßen Wafer aus Silizium mit Oberflächenstrukturen, welcher gemäß dem erfindungsgemäßen Verfahren hergestellt ist. Die Oberfläche ist glatt. Die Maße betragen ca. 2x2 cm. Die Dicke beträgt 100µm.

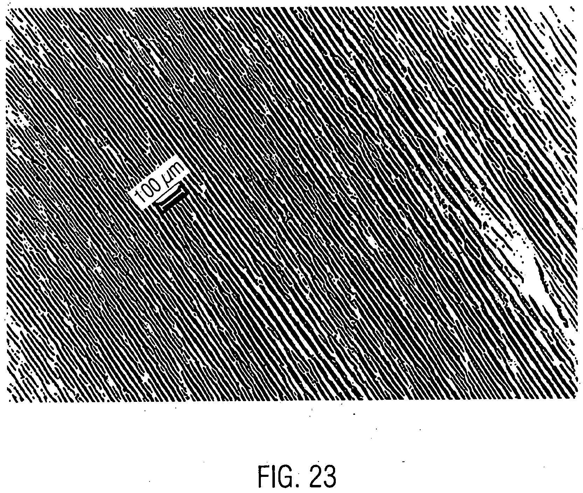

Figur 23 zeigt einen Ausschnitt aus Figur 22a in einer Überblicksansicht.

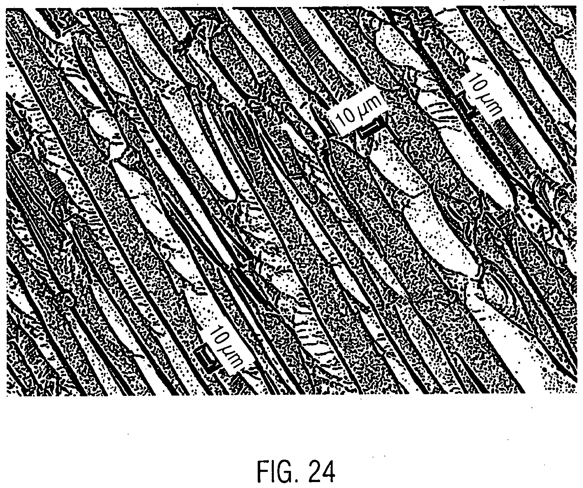

Figur 24 zeigt einen Ausschnitt aus Figur 22a in einer Detailansicht.

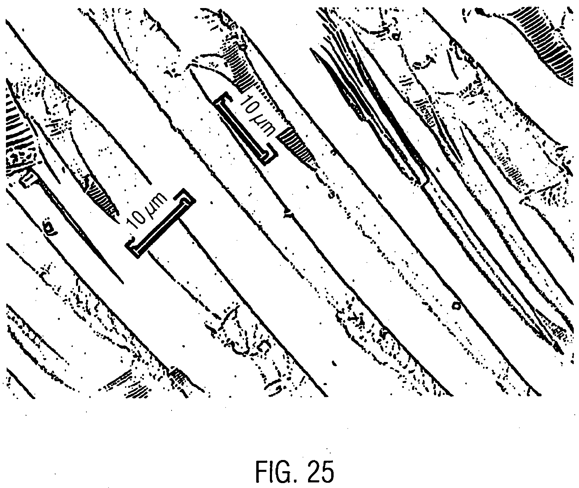

Figur 25 zeigt einen Ausschnitt aus Figur 22a in einer Detailansicht.

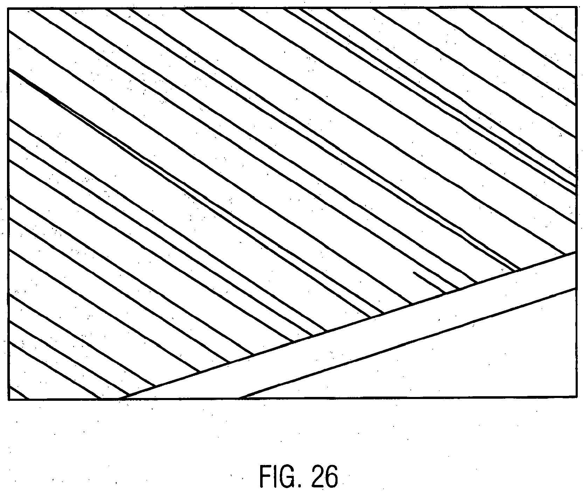

Figur 26 zeigt einen Ausschnitt aus Figur 22b in einer Überblicksansicht.

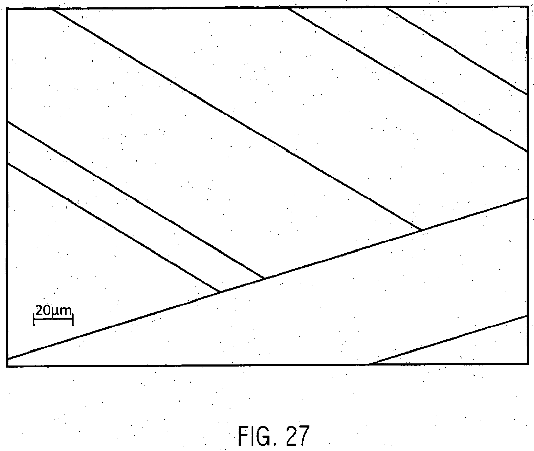

Figur 27 zeigt einen Ausschnitt aus Figur 22b mit ausgeprägten Wallnerlinien in einer Detailansicht.

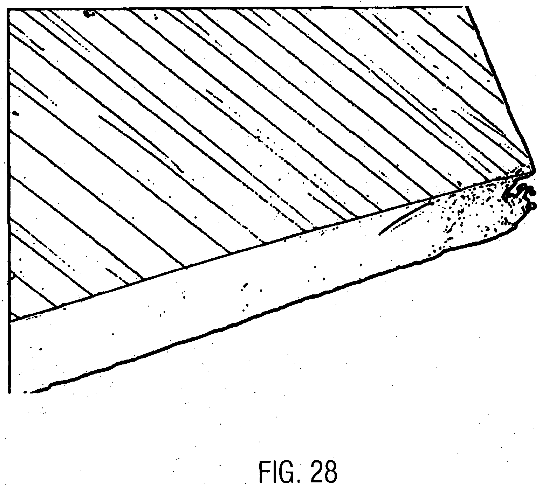

Figur 28 zeigt einen Ausschnitt aus Figur 22b mit ausgeprägten Wallnerlinien in einer Überblicksansicht.

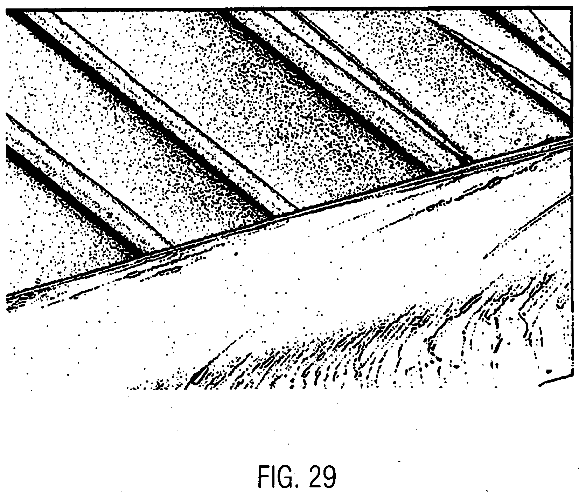

Figur 29 zeigt einen Ausschnitt aus Figur 22b mit ausgeprägten Wallnerlinien in einer Detailansicht.

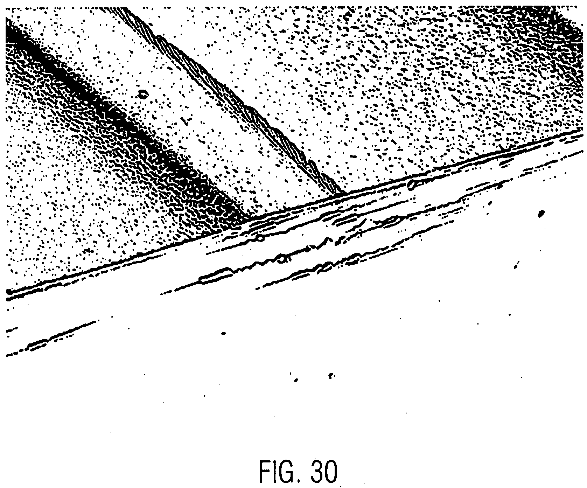

Figur 30 zeigt einen Ausschnitt aus Figur 22b mit ausgeprägten Wallnerlinien in einer Detailansicht.

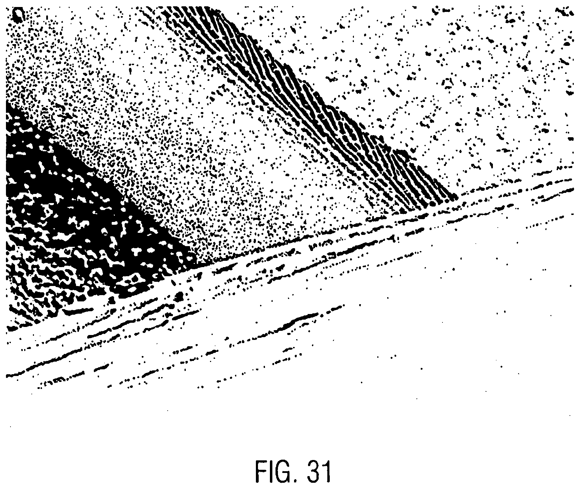

Figur 31 zeigt einen Ausschnitt aus Figur 22b mit ausgeprägten Wallnerlinien in einer Nahansicht.

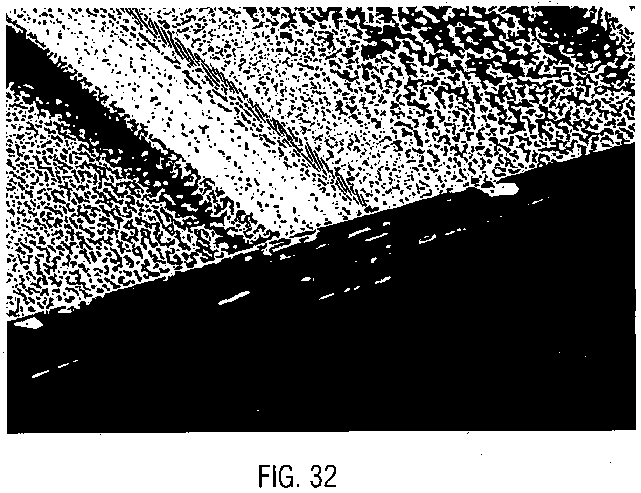

Figur 32 zeigt einen Ausschnitt aus Figur 22b mit ausgeprägten Wallnerlinien in einer Nahansicht.

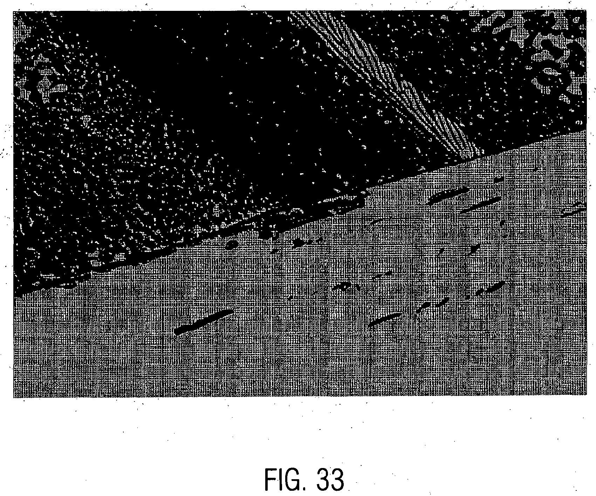

Figur 33 zeigt einen Ausschnitt aus Figur 22b mit ausgeprägten Wallnerlinien in einer Nahansicht.
Figur 34 zeigt einen Ausschnitt aus Figur 22b ohne ausgeprägte Wallnerlinien in einer Überblicksansicht.

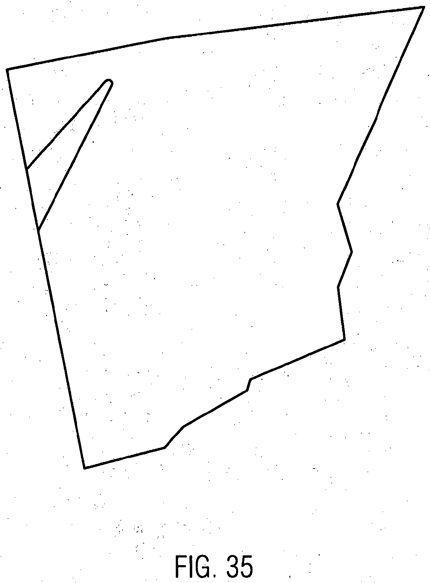

Figur 35 zeigt einen erfindungsgemäßen Wafer aus Silizium mit Oberflächenstrukturen, welcher gemäß dem erfindungsgemäßen Verfahren hergestellt ist. Die Oberfläche ist rauh. Die Maße betragen ca. 2x2cm. Die Dicke beträgt 300µm. Der Wafer wurde aus 600µm dickem monokristallinem Silizium-Wafer, <100> orientiert, drahtgesägt. Der helle Halbkreis am Ende der beiden konisch zusammenlaufenden Linien oben links auf der Probe ist ein Stück aus dem Zentrum eines Wafers, wo die Bruchfronten nicht ganz perfekt zusammengelaufen sind und der Wafer deshalb nicht ganz sauber gesplittet hat.

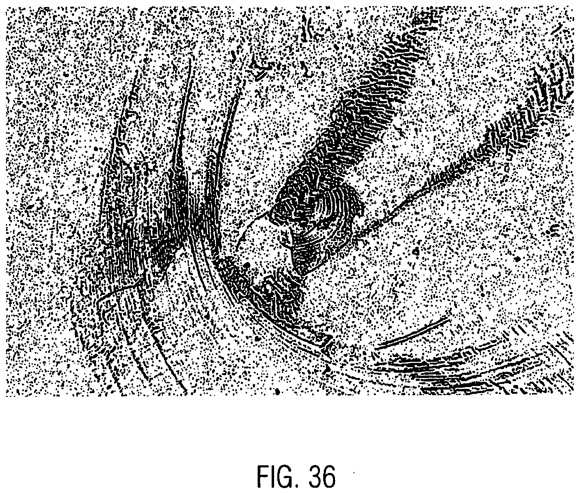

Figur 36 zeigt einen schwach vergrößerten Ausschnitt der Bruchstrukturen im Zentrum des Wafers aus Figur 35

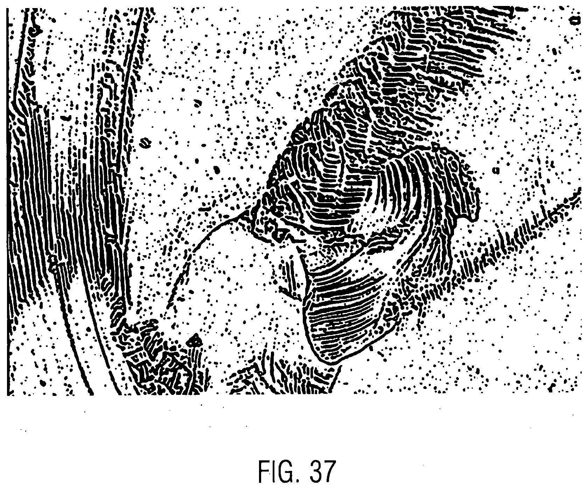

Figur 37 zeigt einen stärker vergrößerten Ausschnitt der Bruchstrukturen im Zentrum des Wafers aus Figur 35, in dem zu erkennen ist, dass die Struktur in der Mitte zwei übereinander liegende Splitebenen aufweist.

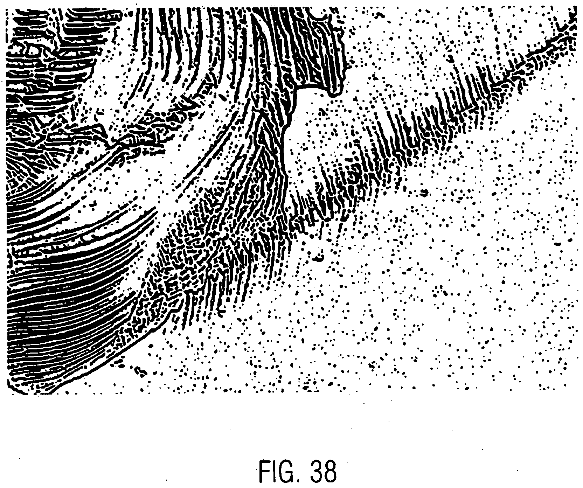

Figur 38 zeigt einen stärker vergrößerten Ausschnitt der Bruchstrukturen im Zentrum des Wafers aus Figur 35, in dem die beiden übereinander liegenden Schichten zu erkennen sind. Am Treffpunkt der beiden Bruchfronten verläuft eine Verwerfung diagonal von links unten nach rechts oben.

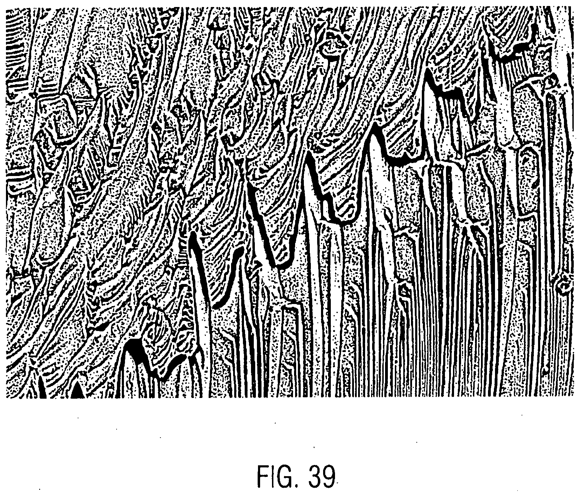

Figur 39 zeigt einen Ausschnitt aus Figur 35 in Detailansicht, in der der Übergang zwischen den beiden in Figur 37 und 38 dargestellten Schichten zu erkennen ist.

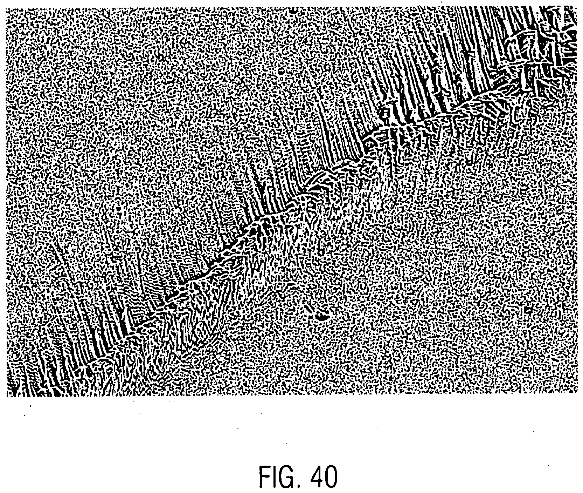

Figur 40 zeigt einen Ausschnitt der Verwerfung aus Figur 38 in Detailansicht.

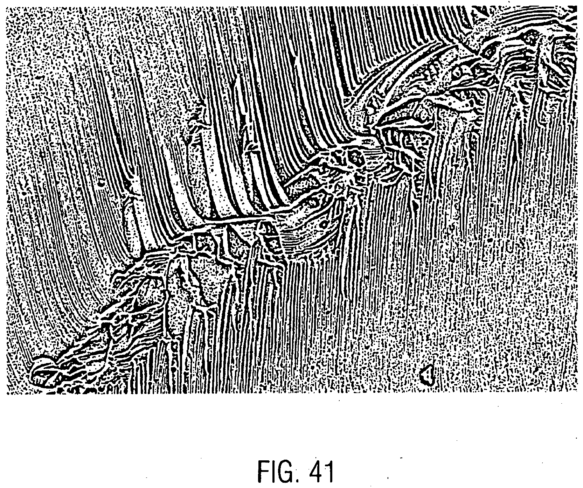

Figur 41 zeigt einen Ausschnitt der Verwerfung aus Figur 38 in Detailansicht.

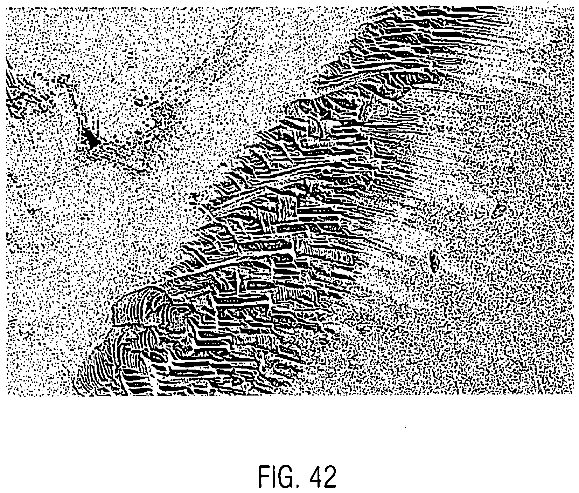

Figur 42 zeigt einen Ausschnitt der Verwerfung aus Figur 38 in Detailansicht.

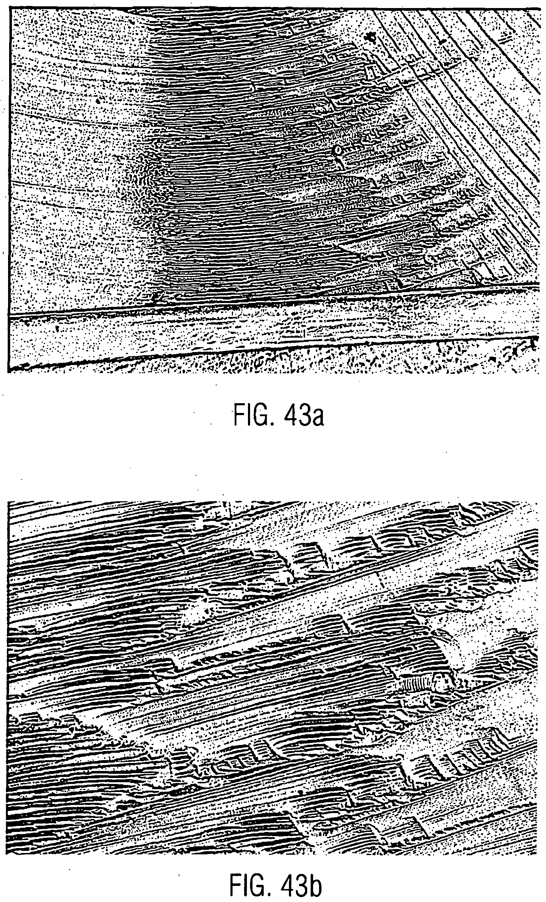

Figur 43a zeigt einen Ausschnitt der Figur 35, in dem Übergänge zwischen größeren und kleineren Rauheiten zu erkennen sind.
Figur 43b zeigt einen Ausschnitt der Figur 35 in Detailansicht, in dem Übergänge zwischen größeren und kleineren Rauheiten zu erkennen sind.
Figur 44 zeigt einen erfindungsgemäßen Wafer aus Silizium mit Oberflächenstrukturen, welcher gemäß dem erfindungsgemäßen Verfahren hergestellt ist. Etwas einwärts von der Kante links unten ist eine rauhe Oberfläche mit Splitansatz sichtbar. Im ungesplitteten Bereich sind Sägeriefen zu erkennen. Die Maße betragen ca. 1,5x1,5cm. Die Dicke beträgt 300µm. Der Wafer wurde aus 600µm dickem monokristallinem Silizium-Wafer, <100> orientiert, drahtgesägt.

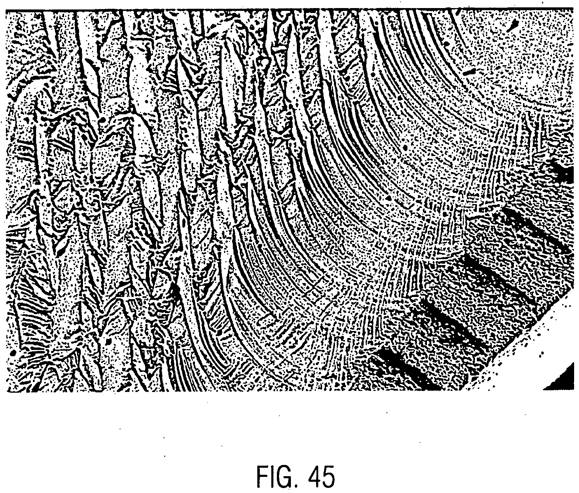

Figur 45 zeigt einen Ausschnitt des Splitansatzes aus Figur 44. Die parallelen breiten Streifen rechts unten sind die Sägeriefen auf der ursprünglichen Waferoberfläche. Unmittelbar links davon beginnt der Split und geht in die Tiefe des Wafers. Interessant ist, dass die Rauheiten der Splitoberfläche links im Bild die gleiche Periode haben wie die Sägeriefen, hier liegt eine deutliche Beeinflussung des Splits durch die Sägeriefen vor.

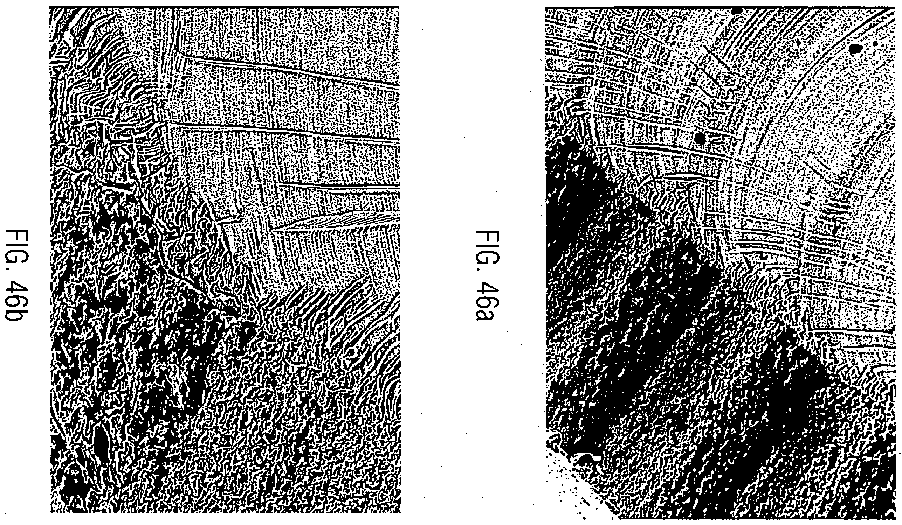

Figur 46a zeigt einen Ausschnitt des Splitansatzes aus Figur 44 mit Sägeriefen.
Figur 46b zeigt einen Ausschnitt des Splitansatzes aus Figur 44 mit Sägeriefen.

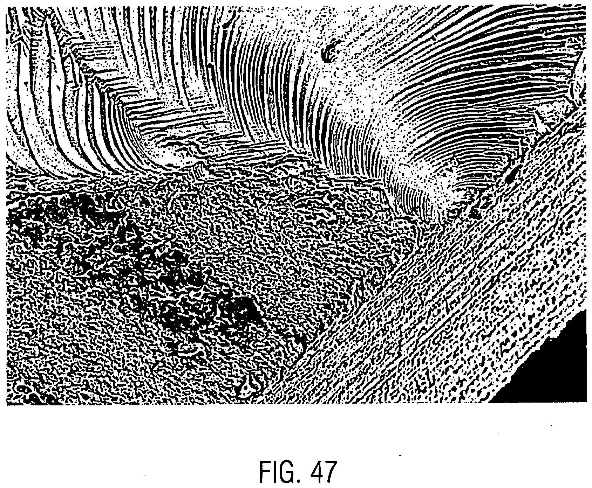

Figur 47 zeigt einen Ausschnitt des Splitansatzes aus Figur 44 mit Sägeriefen bei einer Stelle, wo der Split vom Waferrand her beginnt.

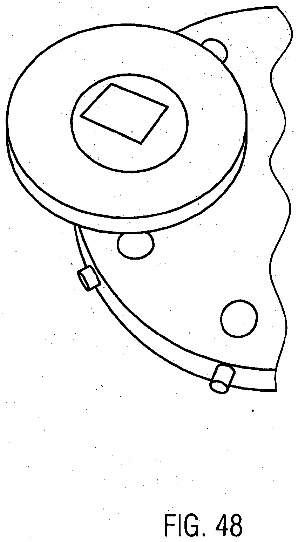

Figur 48 zeigt einen erfindungsgemäßen Wafer aus Galliumarsenid mit Oberflächenstrukturen, welcher gemäß dem erfindungsgemäßen Verfahren hergestellt ist. Die Oberfläche ist rauh. Die Maße betragen ca. 0,5x0,5cm. Die Dicke beträgt 400µm. Der Wafer wurde aus 800µm dickem monokristallinem Galliumarsenid-Wafer, <100> orientiert, drahtgesägt.

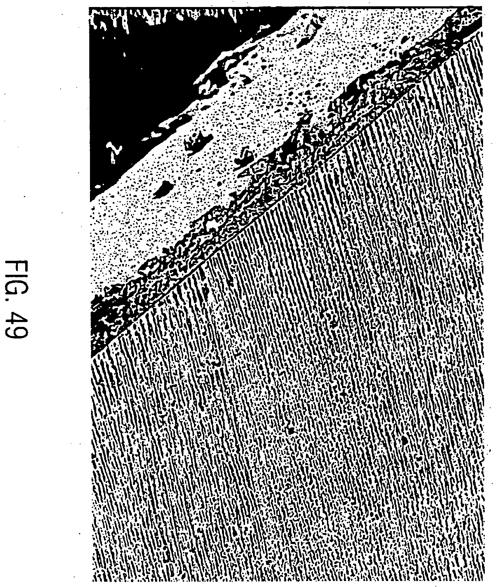

Figur 49 zeigt einen Ausschnitt aus Figur 48, in dem parallele Liniensysteme geringer Amplitude mit schräger laufender Überlagerung zu erkennen sind. Diese Struktur unterscheidet sich von den Oberflächenstrukturen der Silizium-Wafer, die in den Figuren 22a, 22b, 35 und 44 dargestellt sind.

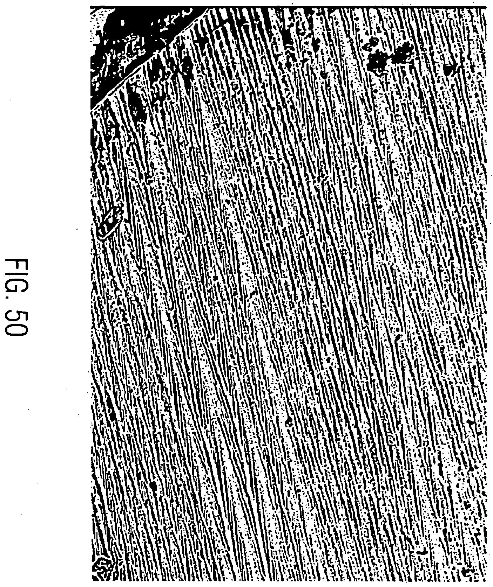

Figur 50 zeigt einen Ausschnitt aus Figur 48 in Detailansicht, in dem parallele Liniensysteme geringer Amplitude mit schräger laufender Überlagerung zu erkennen sind.

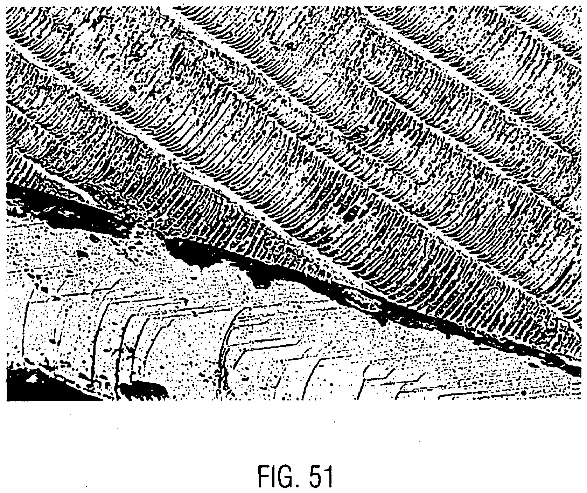

Figur 51 zeigt einen Ausschnitt aus Figur 48, in dem ähnlich wie bei den Silizium-Wafern parallele periodische Liniensysteme mit orthogonal dazu anderen Liniensystemen mit ca. 10 mal kleinerer Periode zu erkennen sind.

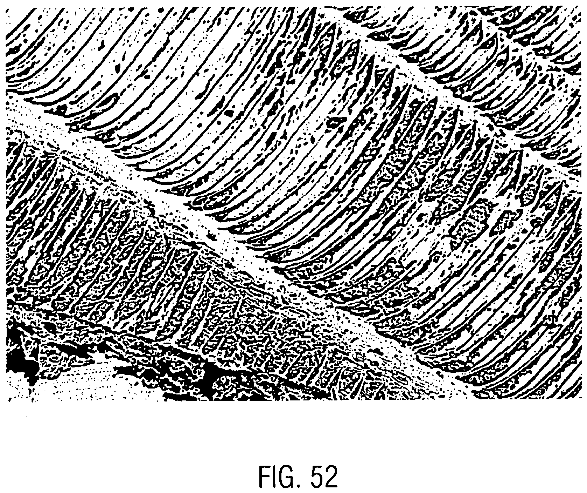

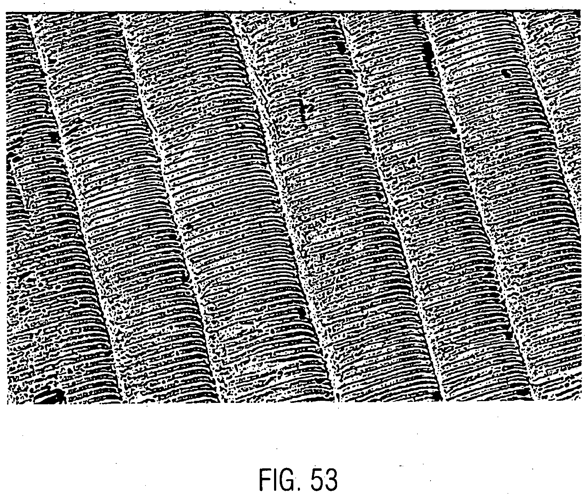

Figur 52 zeigt eine Detailansicht aus Figur 48, in der orthogonale periodische Liniensysteme zu erkennen sind. Das dunkle Material ist Schmutz auf dem Wafer.

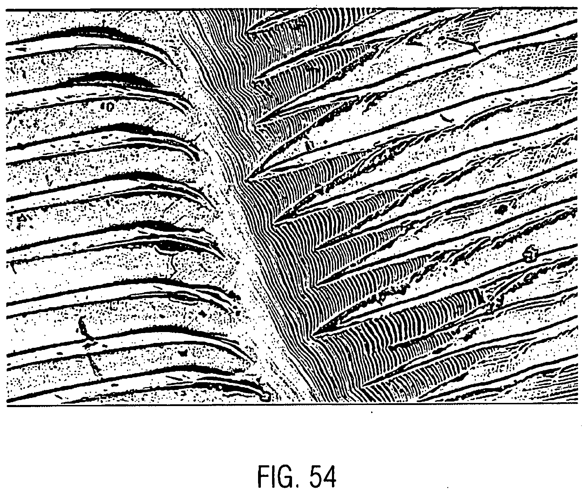

Figur 54 zeigt eine Detailansicht aus Figur 48, in der orthogonale periodische Liniensysteme zu erkennen sind.
Figur 55 zeigt eine Detailansicht aus Figur 48, in der orthogonale periodische Liniensysteme zu erkennen sind.

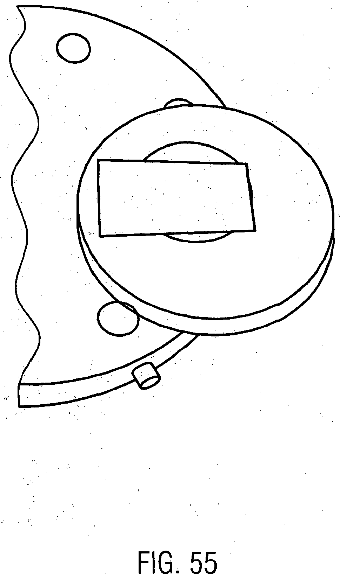

Figur 55 zeigt einen erfindungsgemäßen Wafer aus Galliumarsenid mit Oberflächenstrukturen, welcher gemäß dem erfindungsgemäßen Verfahren hergestellt ist. Die Oberfläche ist mehrheitlich glatt. Die Maße betragen ca. 1,0x0,5cm. Die Dicke beträgt 400µm. Der Wafer wurde aus 800µm dickem monokristallinem Galliumarsenid-Wafer, <100> orientiert, drahtgesägt. Etwas einwärts von der unteren Kante des Wafers ist ein Splitansatz erkennbar.

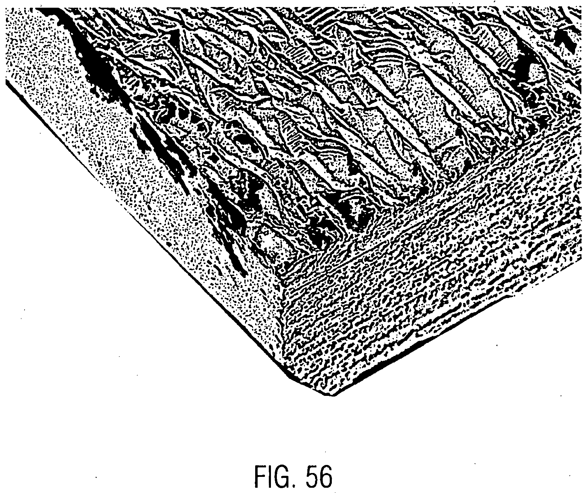

Figur 56 zeigt einen Ausschnitt aus Figur 55, in dem ein Bereich mit sehr rauher Oberfläche ohne ausgeprägte Wallnerlinien zu erkennen ist.

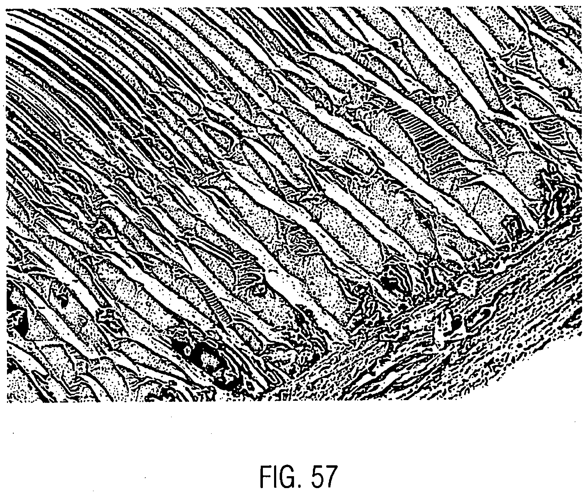

Figur 57 zeigt einen Ausschnitt aus Figur 55, in dem ein Bereich mit sehr rauher Oberfläche ohne ausgeprägte Wallnerlinien zu erkennen ist.

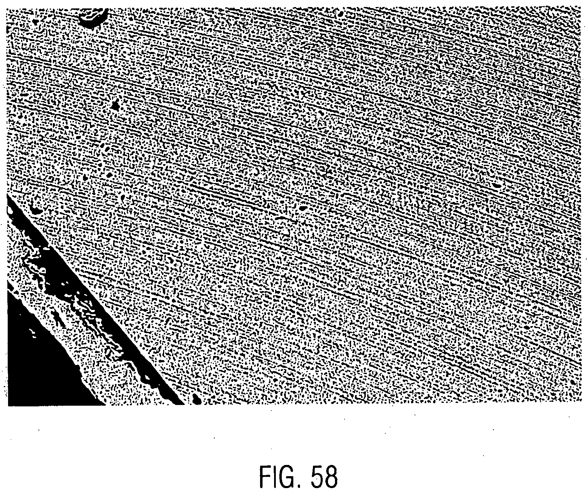

Figur 58 zeigt in einer Überblicksansicht einen Ausschnitt aus Figur 55, in dem ein Bereich mit glatter Oberfläche mit ungefähr periodischen Liniensystemen relativ kleiner Amplitude zu erkennen ist.

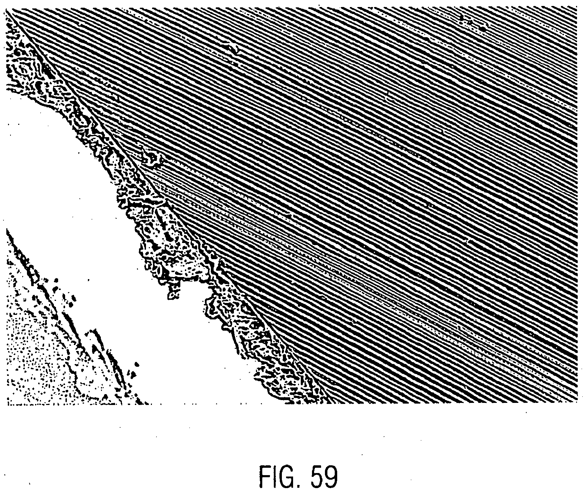

Figur 59 zeigt in einer vergrößerten Ansicht einen Ausschnitt aus Figur 55, in dem ein Bereich mit glatter Oberfläche mit ungefähr periodischen Liniensystemen relativ kleiner Amplitude zu erkennen ist.

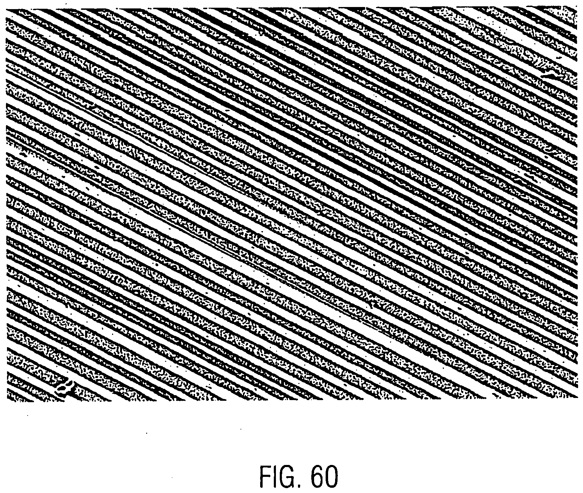

Figur 60 zeigt in einer Detailansicht einen Ausschnitt aus Figur 55, in dem ein Bereich mit glatter Oberfläche mit ungefähr periodischen Liniensystemen relativ kleiner Amplitude zu erkennen ist.

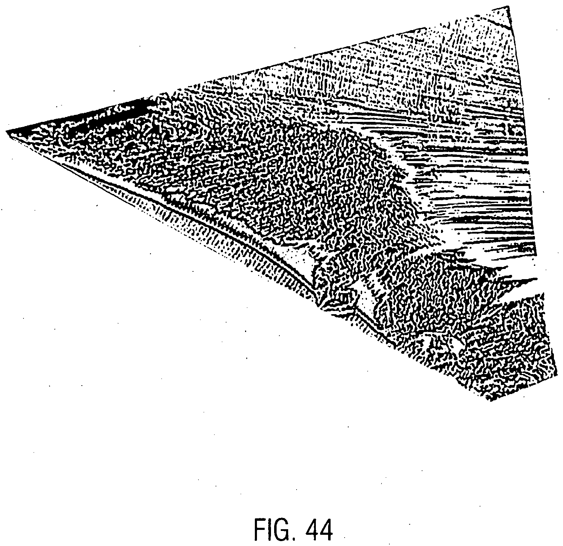

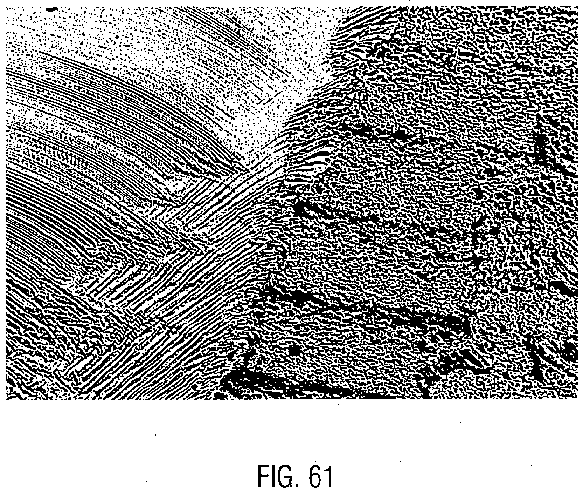

Figur 61 zeigt in einer Detailansicht einen Ausschnitt aus Figur 55, in dem der Splitansatz mit Sägeriefen zu erkennen ist. Er ähnelt dem Splitansatz des Silizium-Wafers in Figur 44.

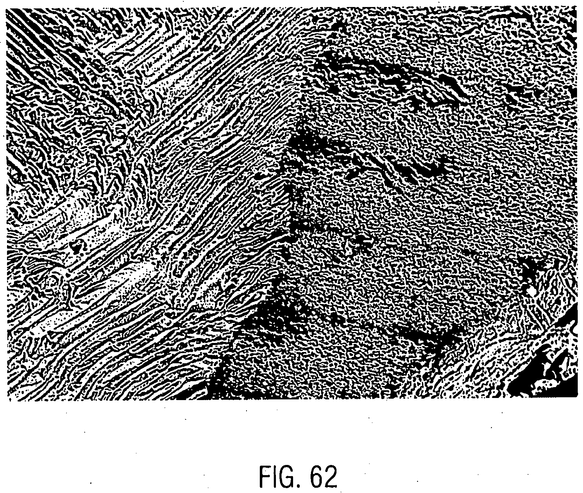

Figur 62 zeigt in einer Detailansicht einen Ausschnitt aus Figur 55, in dem der Splitansatz mit Sägeriefen zu erkennen ist. Er ähnelt dem Splitansatz des Silizium-Wafers in Figur 44.

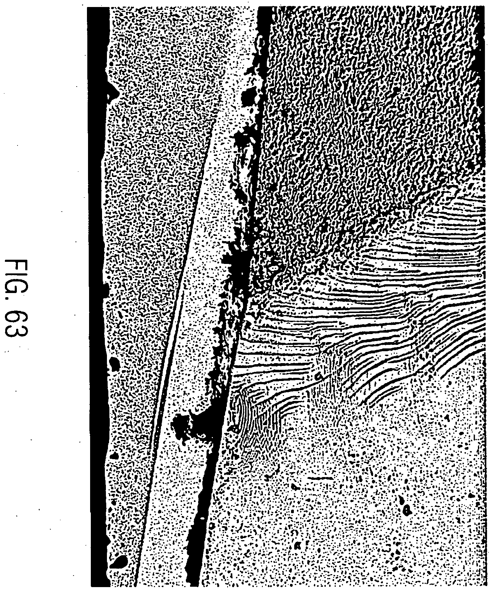

Figur 63 zeigt in einer Detailansicht einen Ausschnitt aus Figur 55, in dem der Splitansatz mit Sägeriefen zu erkennen ist. Er ähnelt dem Splitansatz des Silizium-Wafers in Figur 44. Obwohl der Bruch auch hier durch die Sägereifen beeinflusst wird, ist der Bruchansatz sauber. Ein sauberer Bruchansatz bedeutet, dass die Rauheit schon relativ bald nach Bruchbeginn signifikant kleiner wird.

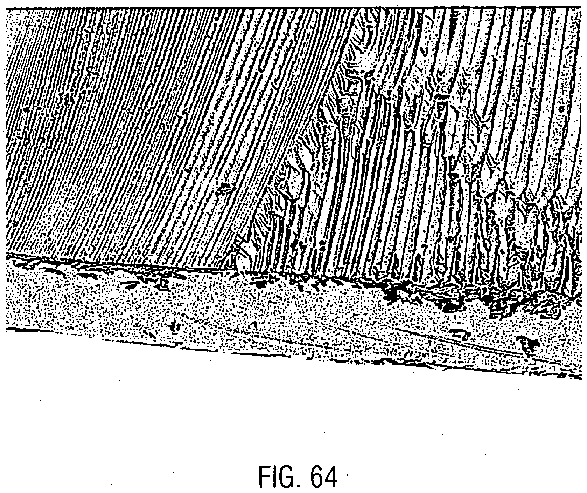

Figur 64 zeigt einen Ausschnitt aus Figur 55, in dem der Übergang zwischen Bereichen unterschiedlicher Rauheit, das heißt mit unterschiedlichen Linienperioden und -amplituden, zu erkennen ist.

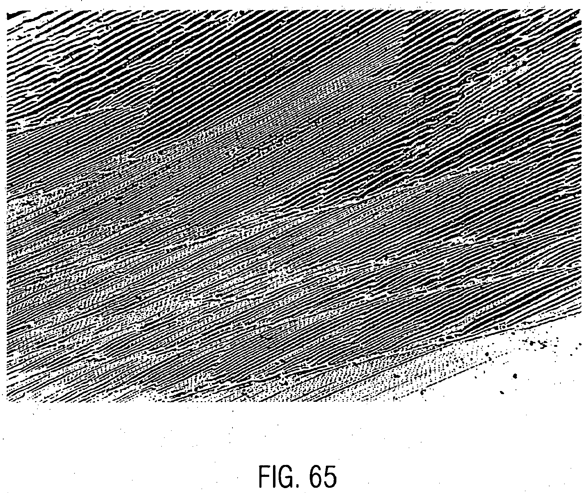

Figur 65 zeigt einen Ausschnitt aus Figur 55, in der eine Überlagerung von zwei nicht-parallelen periodischen Liniensystemen zu erkennen ist.

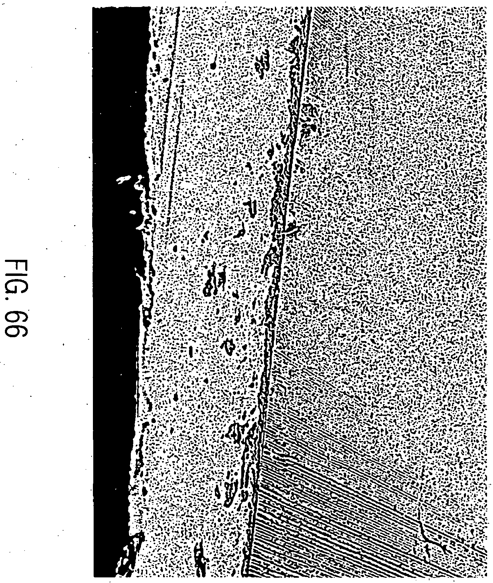

Figur 66 zeigt einen Ausschnitt aus Figur 55 in einer Überblicksansicht, in der eine glatte Oberfläche mit ungefähr periodischen Liniensystemen relativ kleiner Amplitude zu erkennen ist.

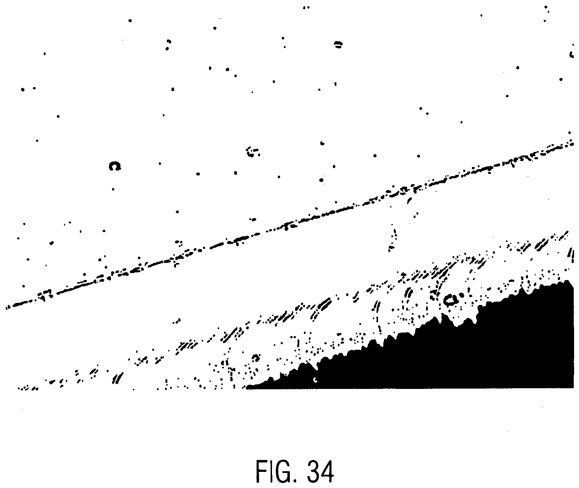

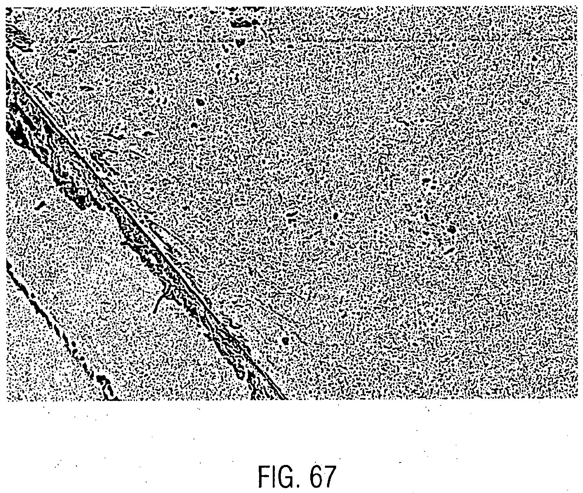

Figur 67 zeigt einen Ausschnitt aus Figur 55 in einer Überblicksansicht, in der eine sehr glatte Oberfläche ohne ausgeprägte Wallnerlinien, ähnlich wie entsprechende Stellen des Silizium-Wafers in Figur 34, zu erkennen ist.

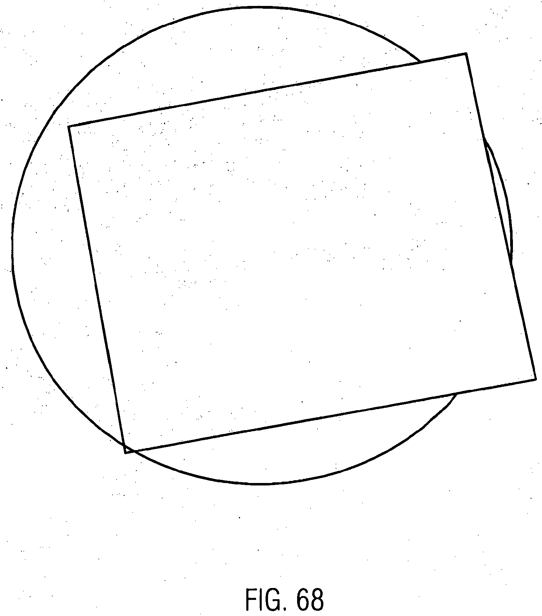

Figur 68 zeigt einen erfindungsgemäßen Wafer aus monokristallinem Silizium mit Oberflächenstrukturen, welcher gemäß dem erfindungsgemäßen Verfahren hergestellt ist. Im oberen Teil schillert die Oberfläche farbig aufgrund periodischer Liniensysteme mit Perioden im Submikrometerbereich. Die Maße betragen ca. 1,5x1,5cm. Die Dicke beträgt 100µm. Der Wafer wurde aus 200µm dickem monokristallinem Silizium-Wafer, <100> orientiert, drahtgesägt.

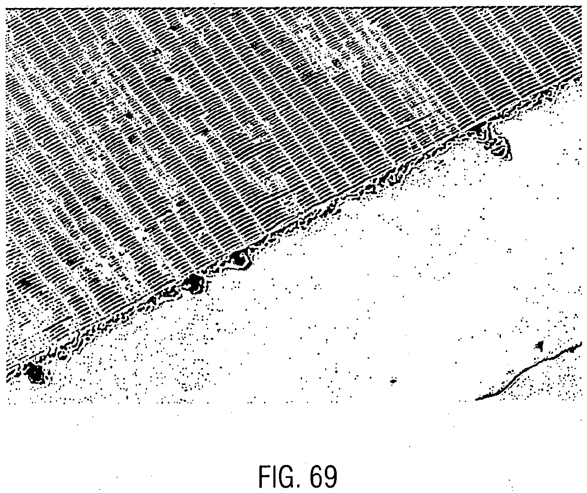

Figur 69 zeigt einen Ausschnitt aus Figur 68 mit periodischen Linienmustern mit Längen von 2-5µm und Breiten/Perioden < 1µm, die aufgrund dieser geringen Perioden farbig schillern. Die Amplitude ist klein.

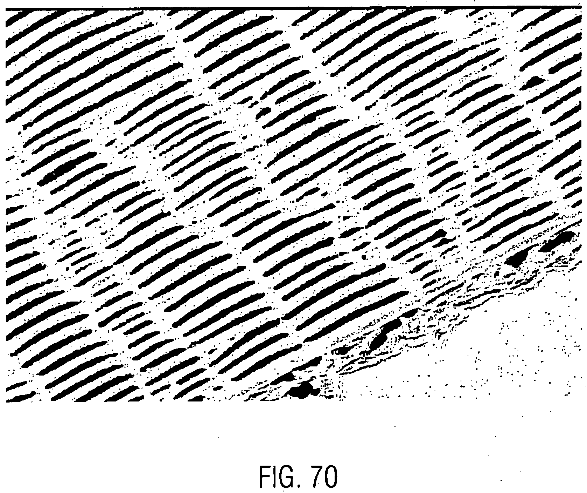

Figur 70 zeigt in einer Detailansicht einen Ausschnitt aus Figur 68 mit periodischen Linienmustern mit Längen von 2-5µm und Breiten/Perioden < 1µm, die aufgrund dieser geringen Perioden farbig schillern.

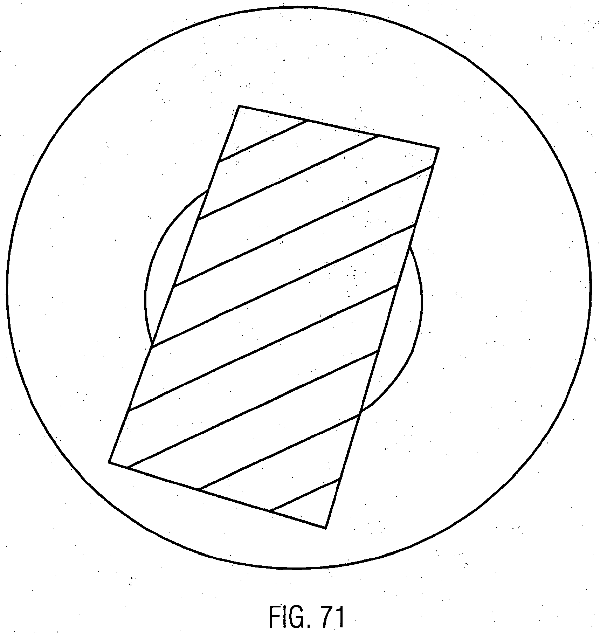

Figur 71 zeigt eine erfindungsgemäße Solarzelle aus monokristallinem Silizium mit Oberflächenstrukturen, welcher gemäß dem erfindungsgemäßen Verfahren hergestellt ist. Die Maße betragen ca. 2x1 cm. Die Dicke beträgt 100µm. Der Wafer wurde aus 200µm dickem monokristallinem Silizium-Wafer, <100> orientiert, drahtgesägt. Beim Splitten bilden sich auf der Splitfläche komplementär u.A. die Kontakte auf der anderen Seite der Zelle ab, erkennbar als dünne Streifen in relativ großem Abstand voneinander. Diese Rasterelektronenaufnahme zeigt eine Solarzelle.

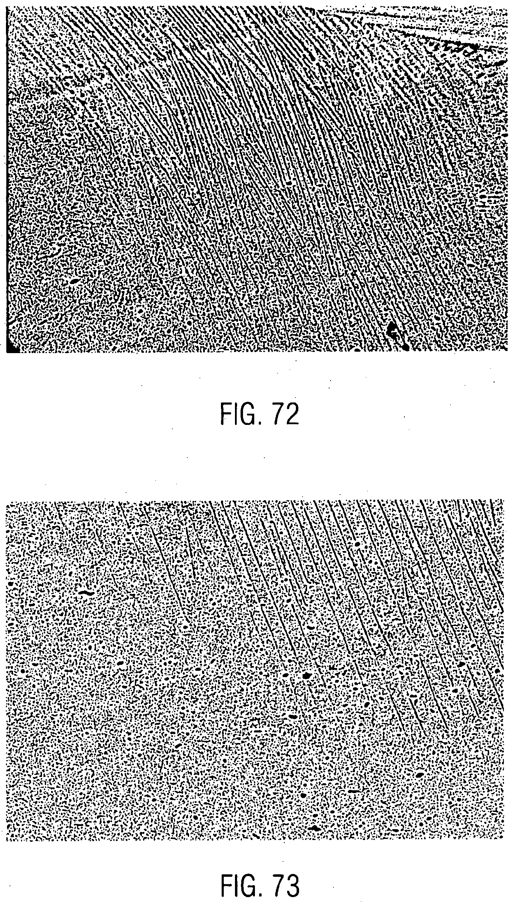

Figur 72 zeigt einen Ausschnit aus Figur 71 mit zwei schwachen Streifen oben und unten im Bild. Diese beiden Abdrücke wurden durch zwei Metallkontakte auf der anderen Seite des Wafers verursacht.
Figur 73 zeigt in Detailansicht einen Ausschnit aus Figur 71 mit einem schwachen Streifen in der Mitte des Bilds. Dieser Abdruck wurde durch einen Metallkontakt auf der anderen Seite des Wafers verursacht.

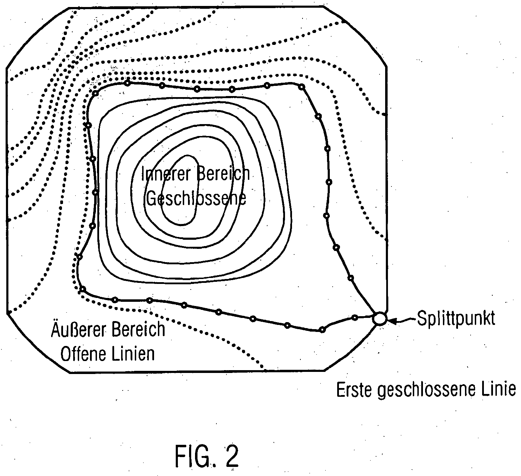

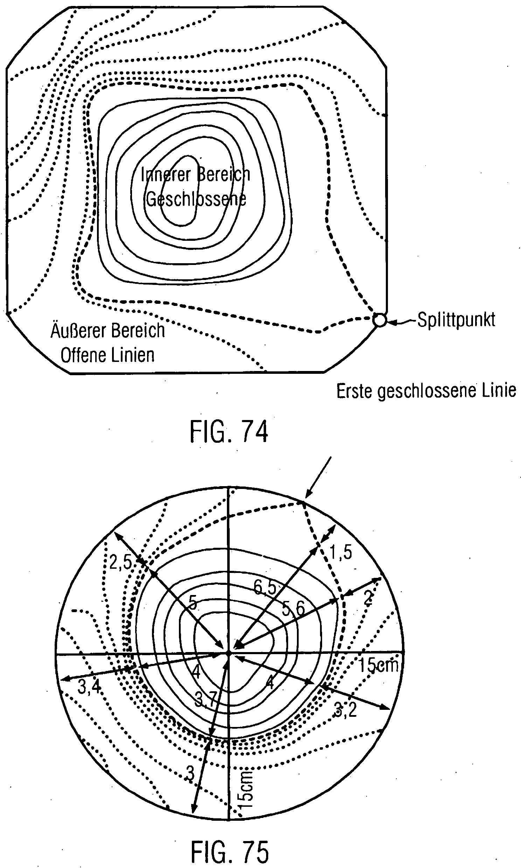

Figur 74 zeigt eine Skizze der Rasterelektronenaufnahme von Fig. 2, welche einen erfindungsgemäßen Wafer mit Oberflächenstrukturen zeigt, welcher gemäß dem erfindungsgemäßen Verfahren aus einem im Wesentlichen rechteckigen Ausgangsmaterial hergestellt ist
Figur 75 zeigt eine Skizze eines erfindungsgemäßen runden Wafers mit Oberflächenstrukturen, welcher gemäß dem erfindungsgemäßen Verfahren hergestellt ist.

Gemäß der Erfindung kann auch nur eine exponierte Oberfläche eines Ausgangsmaterials 4 mit einer Polymerfolie unter Bildung einer Kompositstruktur versehen werden, wobei die Kompositstruktur mit einem inneren und/oder äußeren Spannungsfeld in der Art beaufschlagt wird, so dass das Ausgangsmaterial 4 entlang einer inneren Ebene unter Bildung des Wafers gespalten wird. Dabei entsteht eine abgespaltenen Waferoberfläche mit reliefartigen 3-dimensionale Oberflächenstrukturen, welche durch die Eigenschaften des Ausgangsmaterials vorbestimmbar sind.

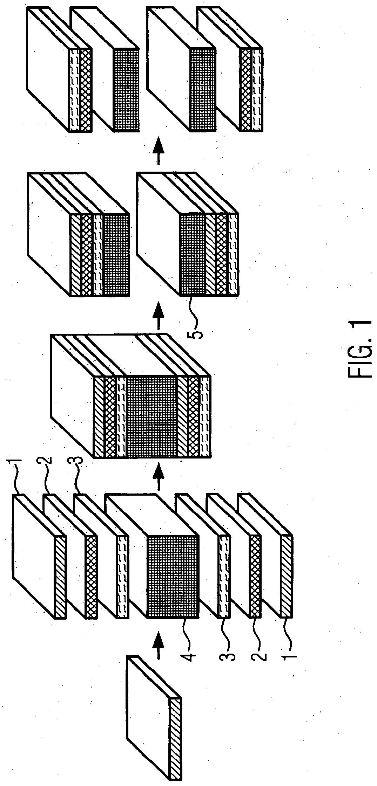

Eine präferierte Realisierung der vorliegenden Erfindung besteht darin, Folien nach einem der hier beschriebenen Verfahren auf beide gegenüberliegende Seiten eines dicken Wafers aufzukleben. Dadurch kann der dicke Wafer in zwei dünne Wafer aufgespalten werden, wie in Fig. 1 dargestellt, wobei die Zahlen in den Kreisen folgendes bezeichnen: (1) Polymerfolie, (2) Kleber, (3) Opferschicht, (4) Werkstück - dicker Wafer, (5) produzierter dünner Wafer.

Die insbesondere mittels diesem Verfahren produzierten dünnen Wafer weisen folgende typischen Charakteristika auf:
Die Wafer können offene und geschlossene Wallnerlinien haben, welche die Art und Weise und auch die Geschwindigkeit der Bruchpropagation bei der Spaltung der Wafer widerspiegeln.

Wie in Fig. 2 gezeigt, verläuft die erste geschlossene Wallnerlinie analog zur äußeren Geometrie des Wafers und besitzt an einer Stelle eine sich zum Rand hin verjüngende Verbindung zum äußeren Rand in einem einzigen Punkt, welcher den Splitpunkt darstellt, von welchem die thermische Abspaltung ausgeht.

Bei runden Wafer ist die erste geschlossene Wallnerlinie eine Art Regentropfen, wobei die runde Grundform mit einer sich zuspitzenden Verbindung zum Rand bis um Splitpunkt verläuft.

Jedoch ist bei einer quadratischen Grundform die erste geschlossene Wallnerlinie ein abgerundetes Viereck mit der Verbindung zum Rand.

Dabei ist der Abstand der ersten geschlossenen Wallnerlinie zum Rand 2,5cm+/- 1 cm, außer dort wo die Verbindung zum Rand die Geometrie stört - da ist er natürlich kleiner und geht gegen Null im Splitpunkt (Fig. 2).

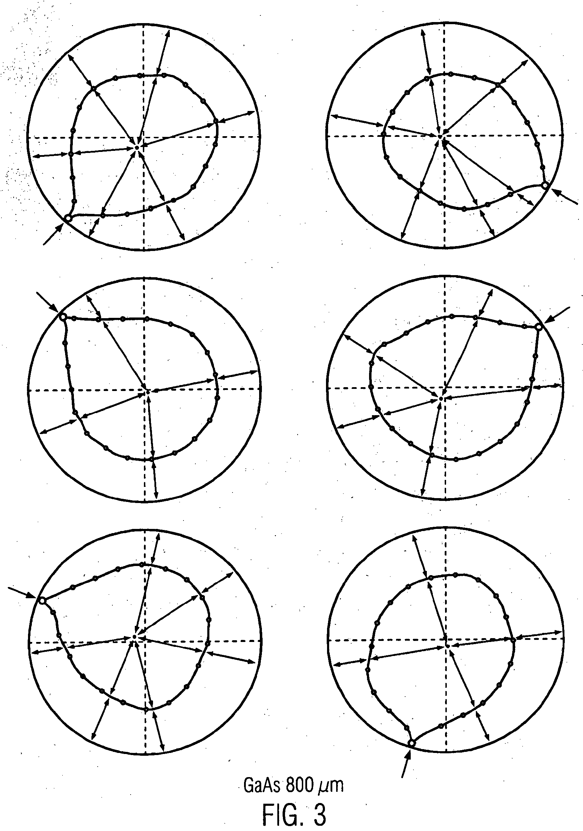

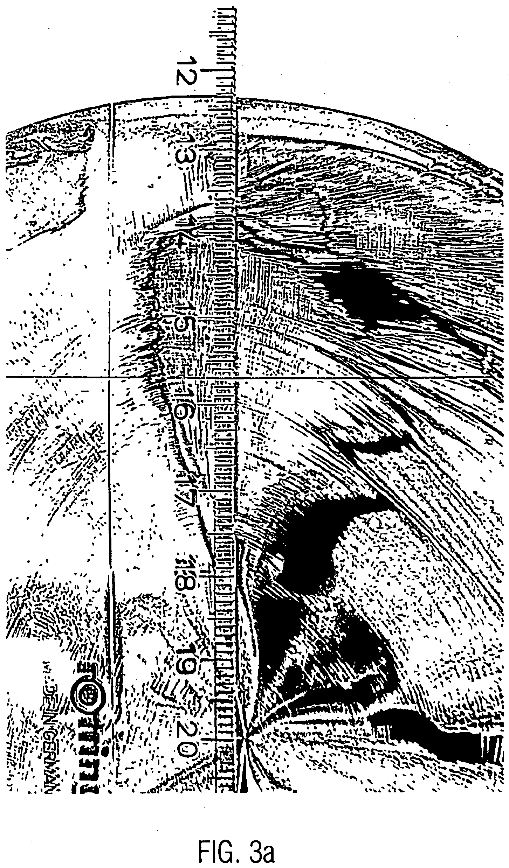

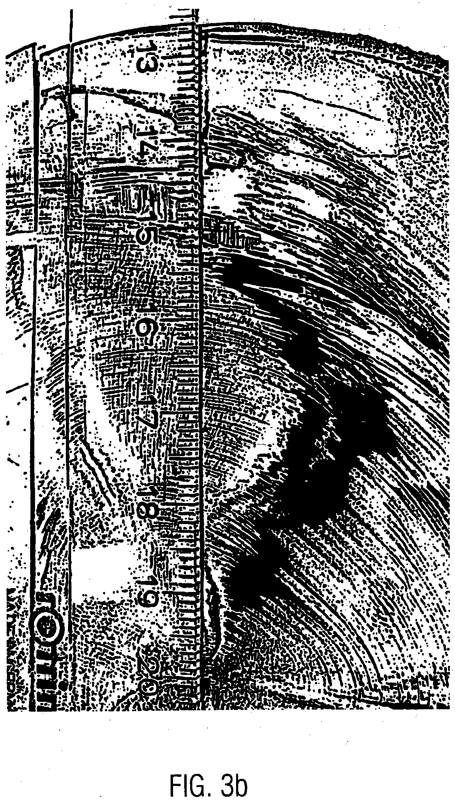

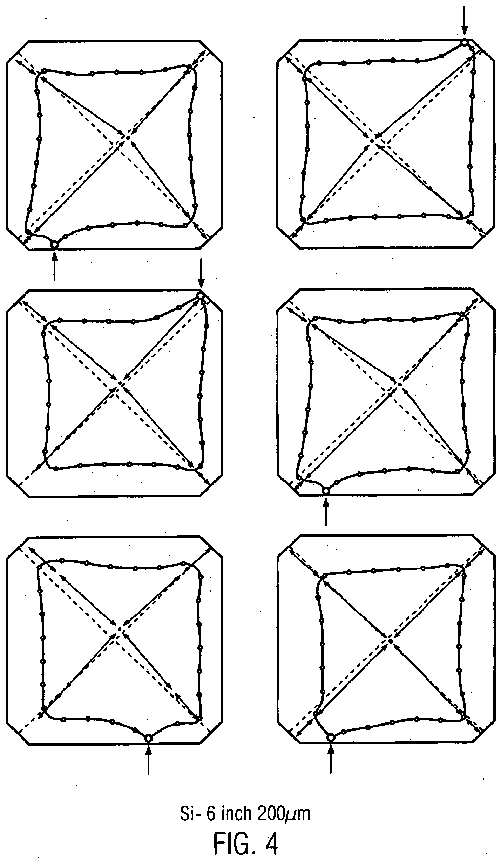

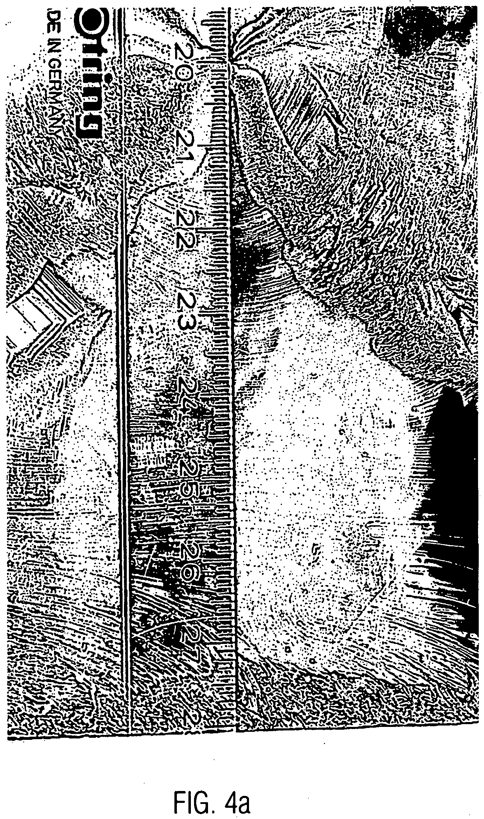

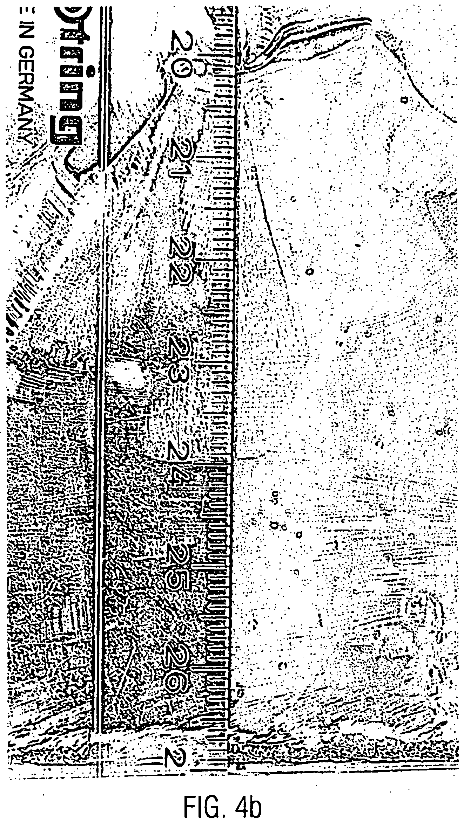

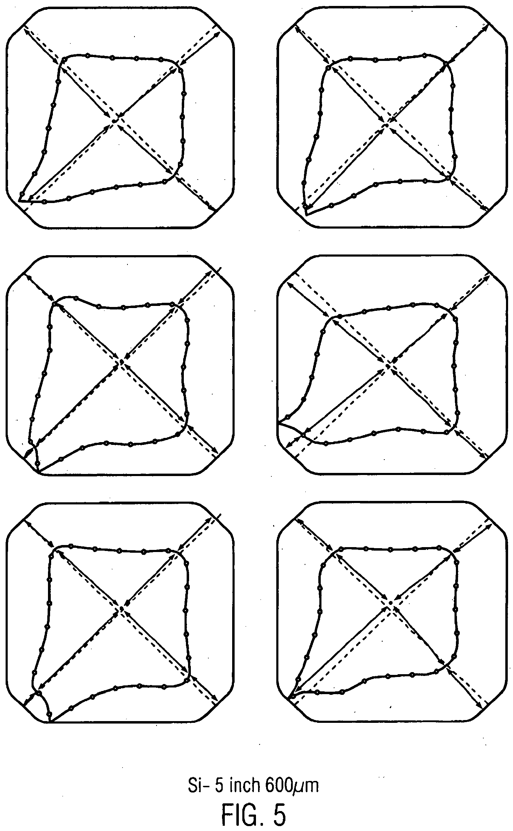

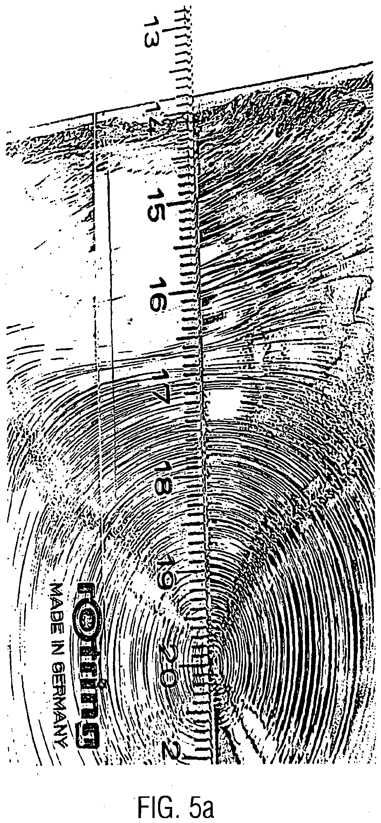

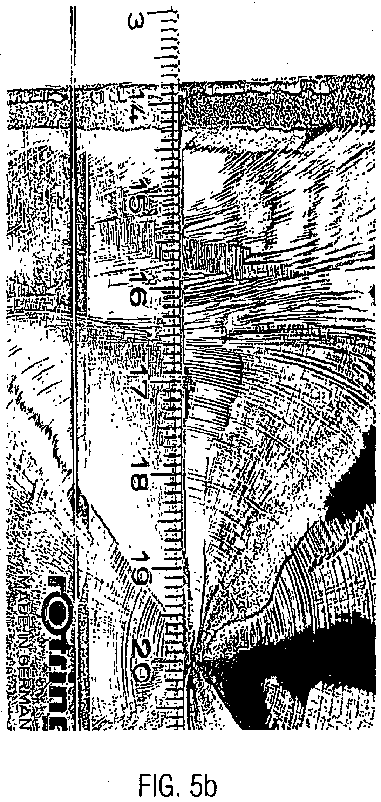

Der Abstand von 2,5cm +/- 1cm ist derselbe gewesen für 800µm GaAs - 6inch rund (Fig. 3 und Fig. 3a), sowie 200µm Si - 6 inch quasiquadratisch (Fig. 4) und 200µm Si- 5 inch quasiquadratisch (Fig. 5, 5a, 5b), wobei dieser nicht beeinflusst ist von der allgemeinen Oberflächenrauhigkeit (Amplitude der Wallnerlinien), von PDMS Schichtdicke, Aushärtetemperatur, mit/ohne SG, mit/ohne Vorkühlen.

Auf der gegenüberliegenden Seite des Splitpunktes gibt es meistens einen weiteren ausgezeichneten Punkt, um dem eine sehr kurze Wallnerlinie ein und wieder austritt. Um diese kürzeste Wallnerlinien liegen dann alle weiteren Wallnerlinien des äußeren Bereiches, so dass sie immer länger werden und ihr Ein- und Austrittspunkt sich von je einer Seite dem Splitpunkt nähert und schließlich der ersten geschlossenen Wallnerlinie annähert. (Fig. 2).

Die Wallnerlinien sind in ihrer Höhenausprägung komplementär auf beiden Waferhälften, also dort wo ein Berg auf einer Waferhälfte ist, befindet sich ein Tal auf der anderen Waferhälfte.

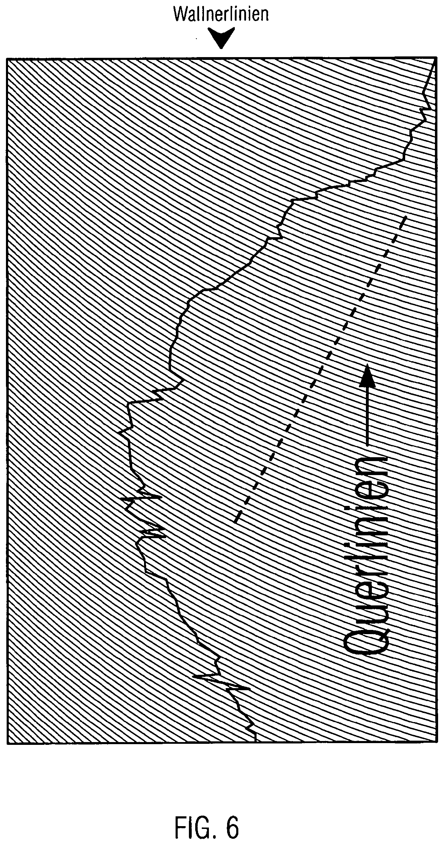

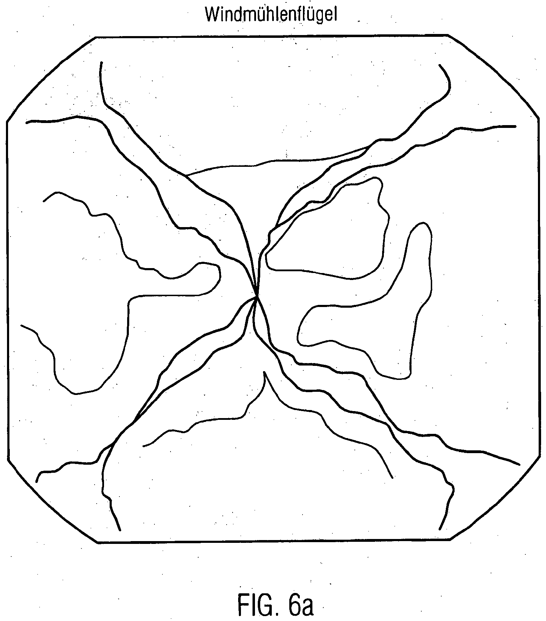

Die Wallnerlinien haben einen Abstand bis zu 1mm voneinander (je dicker der Wafer desto größer der Abstand) - je rauher (je größer die Amplitude der Linie) der Wafer desto größer ist auch der Abstand (Fig. 2 und Fig. 6).

Das Wallnerlinienmuster endet mit einem Punkt oder einem Strich um den sich der erste Kreis/Ellipse befindet, wie in Fig. 2, Fig. 3, Fig. 3a, Fig. 3b, Fig. 4, Fig. 4a, Fig. 4b, Fig. 5, Fig. 5a, Fig. 5B dargestellt. Der Mittelpunkt dieser Struktur befindet sich <1cm vom geometrischen Mittelpunkt des Wafers entfernt (wieder unabhängig von allen Prozessvariationen).

Die Wafer haben offene 1 - 40 mm lange relativ gerade Linien bzw. Querlinien quer zum Wallnerlinienmuster (keine Wallnerlinien, sondern andere Vertiefungen - beidseitig auf dem Wafer und komplementär bzw. nicht komplementär - es kann sich dabei um Kristallrisse handeln (Fig. 6).

Bei quasiquadratischen Wafern befinden sich diese Linie bevorzugt in den Diagonalen und es entsteht eine Art Windmühlenmuster mit einer vierzähligen Geometrie, wie in Fig. 6A dargestellt. Die Querlinien bilden dabei die Windmühlenflügel, die neben einer noch näher zu erläuternden rauhen Mittelstruktur angeordnet sind, wobei bei runden Wafern auch die Windmühlenmuster entstehen, allerdings mit einer nicht am Kristall ausgerichteten Vorzugsrichtung und mit einer Anzahl von 3-6.

Im allgemeinen besitzt die gesplittete Oberfläche eine sehr hohe Reflektion.

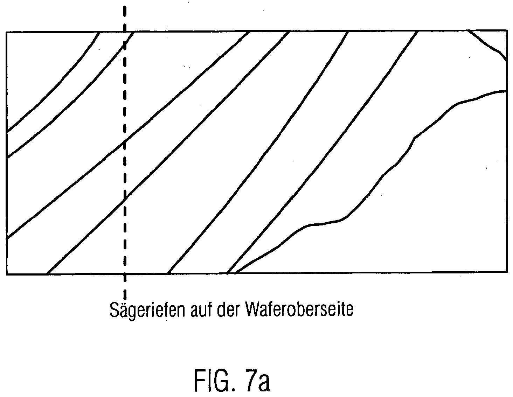

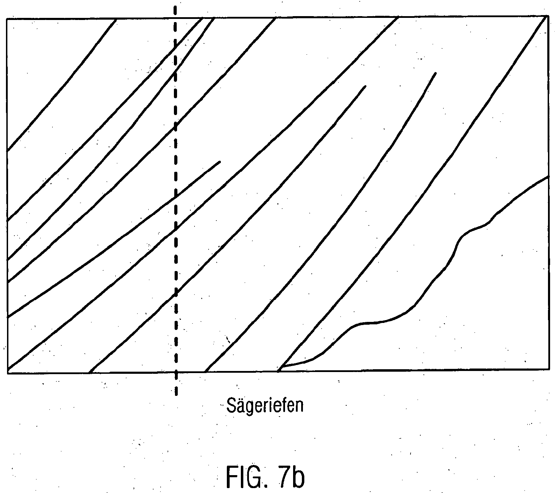

Die Oberflächenstruktur des ungesplitteten Wafers wird auf den Split übertragen - z.B. Sageriefen sind bei dünnen Wafern auch auf der Splitoberfläche deutlich zu erkennen (evt. sind diese bei den dicken im SEM zu sehen), vgl. Fig. 7a und Fig. 7b.

Die Wallnerlinien spiegeln also im wesentlichen die rotationssymmetrischen Schwingungsmoden einer runden Platte wider. Radiale Linien (Querlinien) treten dagegen auf, wenn es auch umlaufende Stehwellen gibt.

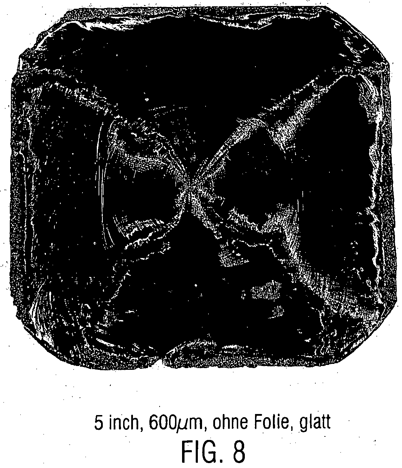

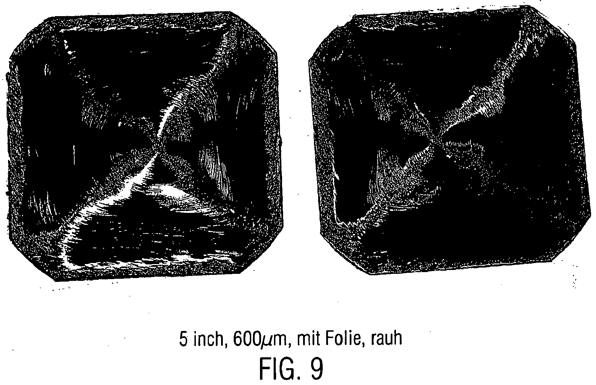

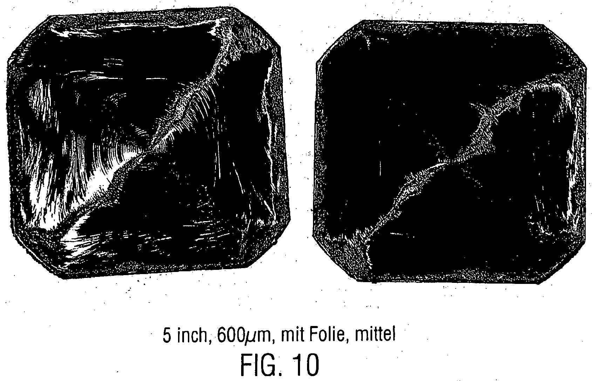

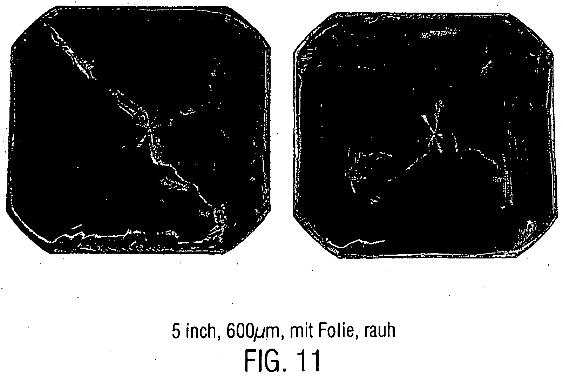

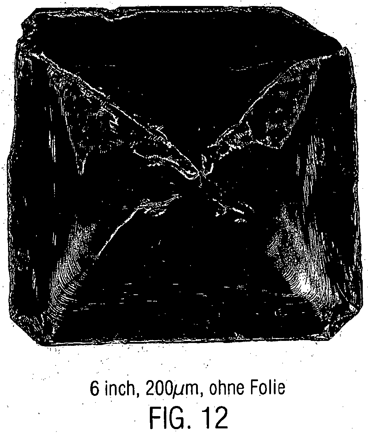

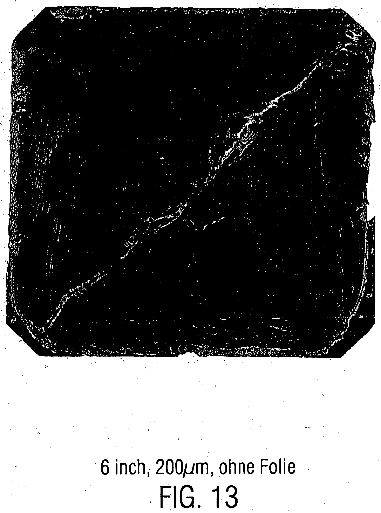

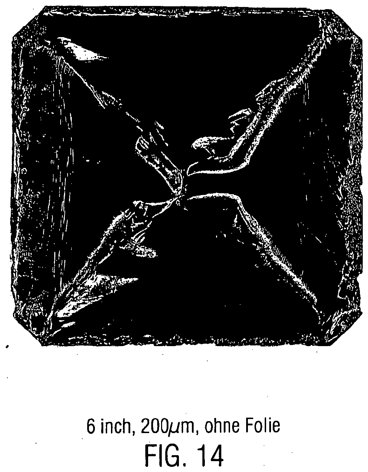

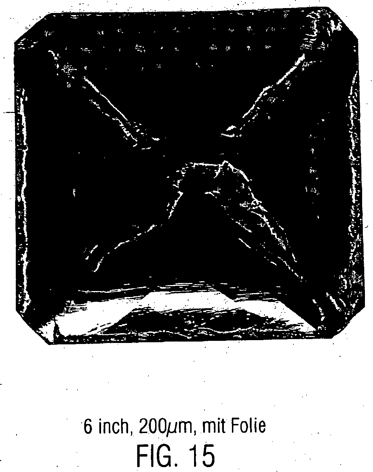

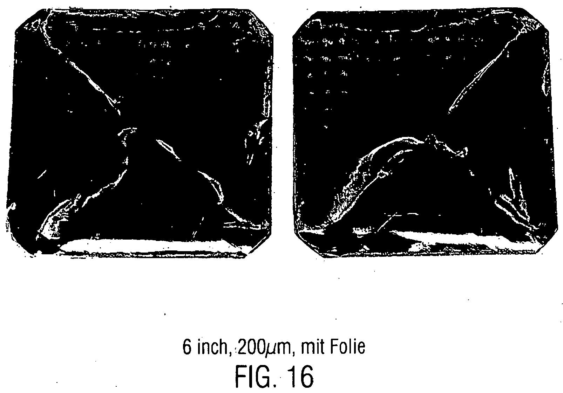

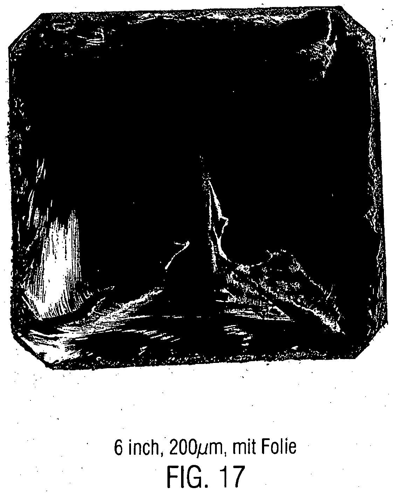

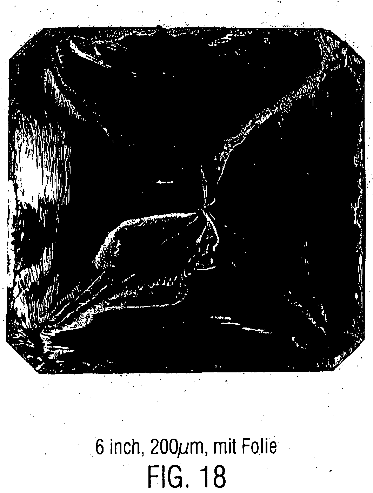

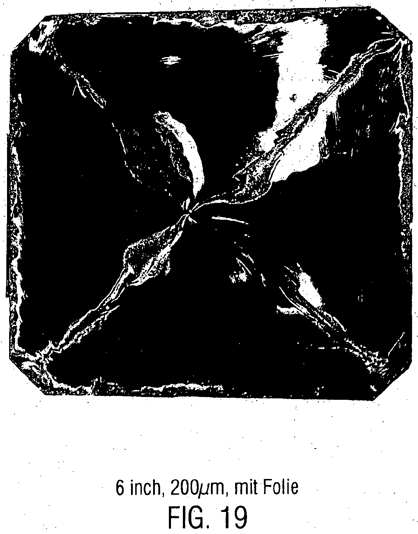

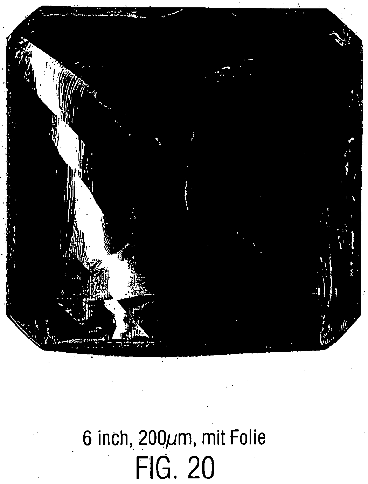

Die Figuren 8 bis 20 zeigen Wafer welche gemäß des erfindungsgemäßen Verfahren hergestellt wurden, wobei die gesplitteten Wafer Oberflächenrauhigkeiten bzw. Oberflächenwelligkeiten unterschiedlichen Grades aufweisen. In besonderen Ausführungsformen handelt es sich hierbei vorzugsweise um GaAs-Material.

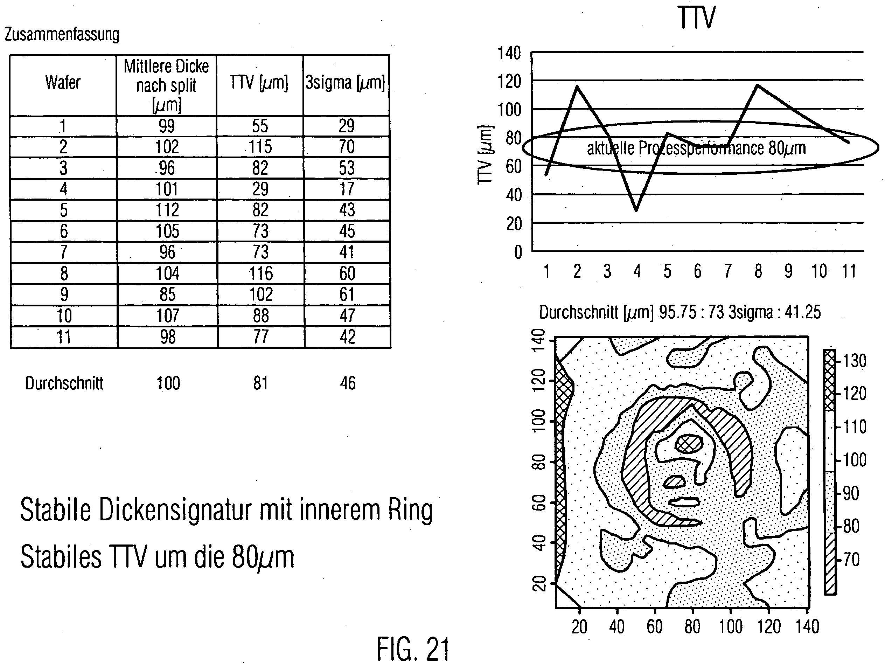

Figur 21 liefert zusammenfassend eine Statistik der beim erfindungsgemäßen Verfahren erzielten Waferdicken.

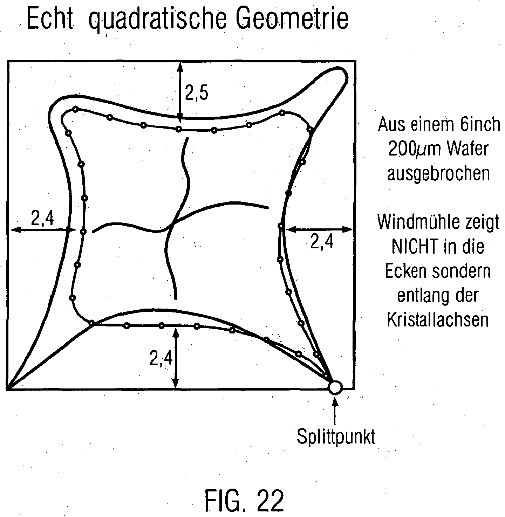

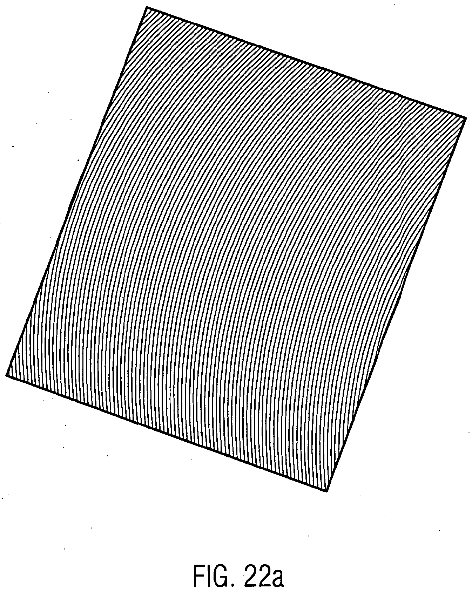

Figur 22a zeigt eine rasterelektronenmikroskopische Untersuchung einer Probe mit besonders rauher Oberfläche. Hier besitzen die parallelen Rillen eine Wellenstruktur mit Perioden von ca. 15µm. Die Rillen sind unregelmäßig und häufig durchbrochen. Auf den Wellenkämmen und in den Wellentälern existiert oft eine ungefähr orthogonal dazu orientierte sekundäre Wellenstruktur mit ca. 10 mal kleineren Perioden. Die Amplituden der Wellen scheinen jeweils ungefähr gleich einem Viertel der Perioden, d.h. ca. 4µm bei der primären Wellenstrukur und ca. 0,4µm bei der sekundären Wellenstruktur. Die Flanken der Wellenberge scheinen flache Ebenen zu sein, d.h. es handelt sich nicht um Sinuswellen, sondern eher um "Sägezahnschwingungen". Die noch zu verifizierende Hypothese für dieses Phänomen lautet, dass die Flanken in den <111>-Kristallebenen liegen. Eine mögliche Erklärung für dieses Phänomen ist, dass der Bruch infolge der Störung die durch den "steady state cracking"-Mechanismus definierte Splitebene verlässt und nach "oben" oder "unten" kurzzeitig entlang einer <111 >-Ebene ausschert, die im Silizium die Kristallebene mit dem schwächsten Zusammenhalt darstellt.

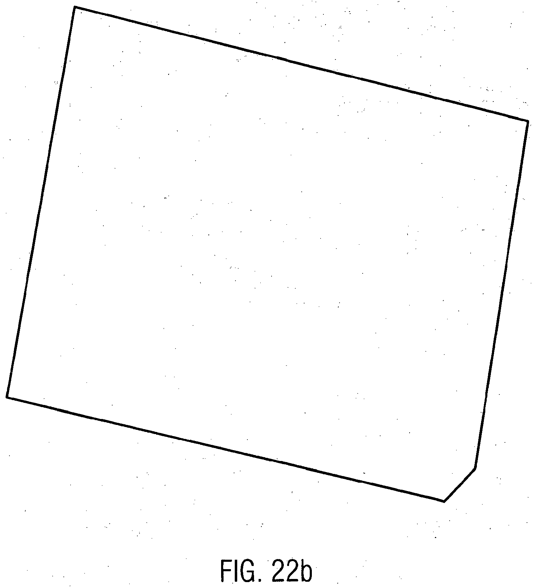

Figur 22b zeigt eine rasterelektronenmikroskopische Untersuchung einer Probe mit besonders glatter Oberfläche. Alle Aufnahmen dieser Probe wurden unter einem Winkel von 30 Grad in der zy-Ebene, von der z-Achse aus gemessen, gemacht. Die z-Achse steht hierbei senkrecht auf den Fotos, die y-Achse vertikal, die x-Achse horizontal). Die Distanzen in y-Richtung in den Bildern müssen deshalb entsprechend skaliert werden. Die Probe zeigt unter dem Elektronenmikroskop Bereiche mit ausgeprägten Wallnerlinien und Bereiche, wo praktisch keine Linien sichtbar sind. In den Bereichen, wo mit dem bloßen menschlichen Auge keine Linien sichtbar sind, sind auch unter dem Elektronenmikroskop keine Strukturen erkennbar. Der Wafer scheint dort über größere Gebiete hinweg praktisch atomar glatt. Wallnerlinien sind bei dieser Probe in Abständen von ca. 100µm messbar. Die Amplitude der Wallnerlinie ist hierbei weitaus kleiner als deren Periode, vermutlich weniger als 1µm. In den Wellentälern zwischen den Wallnerlinien existiert orthogonal zu den Wallnerlinien eine weitaus regelmäßigere Wellenstruktur von parallelen Rillen mit Perioden deutlich unter einem Mikrometer. Die Periode dieser Wellenstruktur ist also ca. 100 mal kleiner als die Periode der Wallnerlinie. Bereiche mit periodischen parallelen Linien mit Periode < 1 µm erscheinen dem menschlichen Auge als typische bunt schillernde Gebiete. An einem Rand der Wallnerlinie findet sich oft eine Art Flechtenstruktur mit Rillen im Submikrometerbereich, die parallel zur Wallnerlinie verläuft. Diese Struktur kann nur an einem Rand der Wallnerlinie vorhanden sein und kann auch parallel zur Wallnerlinie verlaufen. Die kleinen Körner in den Bildern sind nachträgliche Verschmutzungen aus vermutlich organischem Material auf dem Wafer.

Gemäß Figur 74 ist eine Skizze dargestellt, welche einen erfindungsgemäßen Wafer zeigt, welcher einen inneren Bereich mit geschlossenen Wallner- Linien von einem Splittpunkt ausgehend umfasst, der durch einen Kreis mit Pfeil dargestellt ist. Der äußere Bereich außerhalb von der 1. geschlossenen Wallner Linie, Zeigt offene Wallner-Linien, welche sich von beiden Seiten dem Splittpunkt annähern. Dabei befindet sich die kürzeste Wallner-Linie zumeist gegenüber dem Splittpunkt, und wobei Wallner- Linien immer länger werden, wenn sie sich dem Splittpunkt annähern. Analog hierzu zeigt Figur 75 einen runden Wafer, welcher innerhalb der gestrichelten Linie ausgehend von dem durch den Pfeil dargestellten Splittpunkt geschlossenen Wallner- Linien aufweist. Außerhalb der gestrichelten Linie befinden sich in dem Wafer von Figur 75 ebenso offene Wallner-Linien.

Gemäß der Erfindung wird ein Wafer sowie ein entsprechendes Herstellungsverfahren beschrieben, welcher als Ausgangsmaterials (4) einen Werkstoff mit geringer Duktilität aufweist, welches zumindest eine exponierte Oberfläche aufweist, wobei mindestens eine vorgefertigte Aufbringungsschicht (1), welche frei wählbare Materialeigenschaften aufweist, an der exponierten Oberfläche des Ausgangsmaterials (4) unter Bildung einer Kompositstruktur aufgebracht wird, wobei die Kompositstruktur mit einem inneren und/oder äußeren Spannungsfeld in der Art beaufschlagt wird, so dass das Ausgangsmaterial (4) entlang einer inneren Ebene unter Bildung des Wafers gespalten wird, wobei der Wafer reliefartige Oberflächenstrukturen an der sich ergebenden Spalttläche mit im wesentlichen vorbestimmbaren Mustern aufweist, welche durch die Eigenschaften des Ausgangsmaterials variierbar sind.

## Patentansprüche

1. Wafer, welcher als Ausgangsmaterials (4) einen Werkstoff mit geringer Duktilität aufweist, welches zumindest eine exponierte Oberfläche aufweist, wobei mindestens eine vorgefertigte Aufbringungsschicht (1), welche frei wählbare Materialeigenschaften aufweist, an der exponierten Oberfläche des Ausgangsmaterials (4) unter Bildung einer Kompositstruktur aufgebracht wird, wobei die vorgefertigte Aufbringungsschicht eine vorgefertigte Strukturierung aufweist, wobei die Kompositstruktur mit einem inneren und/oder äußeren Spannungsfeld in der Art beaufschlagt wird, so dass das Ausgangsmaterial (4) entlang einer inneren Ebene unter Bildung des Wafers gespalten wird, wobei der Wafer reliefartige Oberflächenstrukturen an der sich ergebenden Spaltfläche mit im wesentlichen vorbestimmbaren Mustern aufweist, welche durch die Eigenschaften des Ausgangsmaterials variierbar sind, wobei die Aufbringungsschicht als eine definiert vorgefertigte Polymerfolie ausgebildet ist, und wobei die Beaufschlagung der Kompositstruktur mit dem Spannungsfeld mittels einem temperaturinduzierten und/oder temperaturgradienteninduzierten mechanischen Spannungsfeld erfolgt, welches die Kompositstruktur entlang einer inneren Ebene des Ausgangsmaterials (4) spaltet.

2. Wafer nach Anspruch 1, welcher Oberflächenstrukturen an der Spaltfläche aufweist, welche durch die exponierte Oberfläche und die Randgeometrie des Ausgangsmaterials derart vorbestimmbar sind, dass die Oberfläche an der Spaltfläche komplementär zur exponierten Oberfläche und/oder komplementär zur Randgeometrie des Ausgangsmaterials ist.

3. Wafer nach Anspruch 1 oder 2, wobei die Oberflächenstrukturen an der sich ergebenden Spaltfläche im wesentlichen vorbestimmbare Muster in Form von offenen und geschlossenen Wallnerlinien aufweisen, und wobei die geschlossenen Wallnerlinien im wesentlichen der Randgeometrie des Ausgangsmaterials entsprechen.

4. Wafer nach nach einem der Ansprüche 1- 3, wobei die Oberflächenstrukturen an der sich ergebenden Spaltfläche im wesentlichen vorbestimmbare Muster in Form von Wallnerlinien und im Wesentlichen quer zu diesen verlaufende Relieflinien aufweisen.

5. Wafer nach einem der Ansprüche 1 - 4, wobei die Aufbringungsschichten (1), insbesondere die Polymerfolien bzgl. ihrer physikalischen Eigenschaften definiert vorgefertigt werden und/oder gehärtet und/oder getempert werden, insbesondere bezgl. verschiedener Schichtdicken insbesondere im Bereich von 0,1 - 10 mm, insbesondere von 0,4 - 1 mm, verschiedener insbesondere temperaturabhängiger elastischer Konstanten und/oder Ausdehnungskoeffizienten.

6. Wafer nach einem der Ansprüche 1 - 5, wobei die Aufbringungsschichten (1), insbesondere die Polymerfolien (1) derart in Relation zur Form des zu spaltenden Ausgangsmaterials (4) zugeschnitten

7. Wafer nach einem der Ansprüche 1 - 6, wobei zwei oder mehrere Aufbringungsschichten (1) ah der Oberfläche oder an zwei gegenüberliegenden Oberflächen des Ausgangsmaterials, insbesondere Polymerfolien, unabhängig voneinander und unabhängig von dem zu spaltenden Ausgangsmaterial (4) hergestellt werden, insbesondere bei voneinander unabhängigen Temperaturen ausgehärtet werden.

8. Wafer nach einem der Ansprüche 1 - 7, wobei die Aufbringungsschichten, insbesondere die Polymerfolien (1) eine vorgefertigte Strukturierung aufweisen, insbesondere lateral varierende Dickenprofile und/oder lokal variierende elastische Konstanten und/oder lokal variierende thermische Ausdehnungskoeffizienten, und wobei das Polymer ein Polydiorganosiloxan ist, insbesondere Polydimethylsiloxane (PDMS).

9. Wafer nach einem der Ansprüche 1 - 8, wobei das zu spaltende Ausgangsmaterial (4) insbesondere Silizium und/oder Germanium/und/oder Saphir und/oder Diamant und/oder Glas und/oder Siliziumnitrid ist, und wobei die Aufbringungsschicht oder Polymerfolie aus einem viskos-flüssigen Zweikomponentenmaterial hergestellt wird, insbesondere PDMS, welche insbesondere durch ein Gießverfahren auf einer planen Oberfläche und anschließendem Aushärten hergestellt wird.

10. Wafer nach einem der Ansprüche 1 - 9, wobei die vorgefertigte Aufbringungsschicht, insbesondere die vorgefertigte Polymerfolie fest auf dem zu spaltenden Ausgangsmaterial (4) mittels eines Klebstoffes, insbesondere durch Ausrollen unter Zuhilfenahme einer Andruckrolle oder Walze fixiert wird, und wobei eine Klebstoffschicht (2) zwischen Ausgangsmaterial (4) und Aufbringungsschicht (1) vorgesehen ist, wobei die Klebstoffschicht insbesondere als PDMS-Film vorgesehen ist.

11. Wafer nach einem der Ansprüche 1 - 10, wobei das Ausgangsmaterial (4) aus Galliumarsenid aufgebaut Ist.

12. Verfahren zur Herstellung eines Wafers nach einem der Ansprüche 1 - 11, insbesondere.zur Herstellung von dünnen Wafern aus Silizium und/oder Germanium/und/oder Saphir und/oder Diamant und/oder Glas und/oder Siliziumnitrid und/oder Galliumarsenid.

## Claims

1. A wafer, which comprises as a starting material (4) a material with a low ductility, which comprises at least one exposed surface, wherein at least one prefabricated application layer (1), which has freely selectable material properties, is applied to the exposed surface of the starting material (4) thereby forming a composite structure, wherein the prefabricated application layer comprises a prefabricated structuring, wherein the composite structure is subjected to an internal and/or external stress field in such a way that the starting material (4) is cleaved along an inner plane thereby forming the wafer, wherein the wafer comprises relief-like surface structures at the resultant cleavage face with essentially pre-definable patterns, which can be varied through the properties of the starting material, wherein the application layer is constituted as a polymer film prefabricated in a defined manner, and wherein the subjecting of the composite structure to the stress field takes place by means of a temperature-induced and/or temperature gradient-induced mechanical stress field, which cleaves the composite structure along an inner plane of the starting material (4).

2. The wafer according to claim 1, which comprises surface structures at the cleavage face, which are pre-definable by the exposed surface and the edge geometry of the starting material, in such a way that the surface at the cleavage face is complementary to the exposed surface and/or complementary to the edge geometry of the starting material.

3. The wafer according to claim 1 or 2, wherein the surface structures at the resultant cleavage face comprise essentially pre-definable patterns in the form of open and closed Wallner lines, and wherein the closed Wallner lines essentially correspond to the edge geometry of the starting material.

4. The wafer according to any one of claims 1 - 3, wherein the surface structures at the resultant cleavage face comprise essentially pre-definable patterns in the form of Wallner lines and relief lines running essentially normal to the latter.

5. The wafer according to any one of claims 1 - 4, wherein the application layers (1), in particular the polymer films, are prefabricated in a defined manner with respect to their physical properties and/or are hardened and/or tempered, in particular with respect to different layer thicknesses especially in the range from 0.1 - 10 mm, in particular from 0.4 - 1 mm, various in particular temperature-dependent elastic constants and/or expansion coefficients.

6. The wafer according to any one of claims 1 - 5, wherein the application layers (1), in particular the polymer films (1), are cut to size in relation to the form of the starting material (4) to be cleaved, in such a way that a precisely defined edge termination of the composite structure is thus ensured.

7. The wafer according to any one of claims 1 - 6, wherein two or more application layers (1) at the surface or at two opposite surfaces of the starting material, in particular polymer films, are produced independently of one another and independently of the starting material (4) to be cleaved, in particular are hardened at temperatures independent of one another.

8. The wafer according to any one of claims 1 - 7, wherein the application layers, in particular the polymer films (1), comprise a prefabricated structuring, in particular laterally varying thickness profiles and/or locally varying elastic constants and/or locally varying thermal expansion coefficients, and wherein the polymer is a polydiorganosiloxane, in particular polydimethyl siloxanes (PDMS).

9. The wafer according to any one of claims 1 - 8, wherein the starting material (4) to be cleaved is in particular silicon and/or germanium and/or sapphire and/or diamond and/or glass and/or silicon nitride, and wherein the application layer or polymer film is produced from a viscous-fluid two-component material, in particular PDMS, which is produced in particular by a casting process on a plane surface and subsequent hardening.

10. The wafer according to any one of claims 1 - 9, wherein the prefabricated application layer, in particular the prefabricated polymer film, is firmly fixed on the starting material (4) to be cleaved by means of an adhesive, in particular by rolling with the aid of a pressure roll or roller, and wherein an adhesive layer (2) is provided between the starting material (4) and the application layer (1), wherein the adhesive layer is provided in particular as a PDMS film.

11. The wafer according to any one of claims 1 - 10, wherein the starting material (4) is constituted by gallium arsenide.

12. A method for producing a wafer according to any one of claims 1 - 11, in particular for producing thin wafers of silicon and/or germanium and/or sapphire and/or diamond and/or glass and/or silicon nitride and/or gallium arsenide.

## Revendications

1. Tranche, laquelle comporte en tant que matériau de départ (4) une matière à faible ductilité, laquelle comporte au moins une surface exposée, sachant qu'on applique au moins une couche d'application (1) préfabriquée qui fait preuve de propriétés de matière librement sélectionnables sur la surface exposée du matériau de départ (4) en formant une structure composite, la couche d'application préfabriquée comportant une structuration préfabriquée, sachant qu'on soumet la structure composite à un champ électrique intérieur et/ou extérieur, de telle sorte que le matériau de départ (4) se fende le long d'un plan intérieur, en formant la tranche, la tranche comportant sur la face fendue résultante des structures superficielles formant des reliefs avec des motifs sensiblement prédéfinissables que l'on peut faire varier par les propriétés du matériau de départ, la couche d'application étant conçue sous la forme d'un film de polymère préfabriqué défini et la soumission de la structure composite au champ électrique s'effectuant à l'aide d'un champ électrique mécanique, induit par température et/ou induit par gradient thermique, lequel fend la structure composite le long d'un plan intérieur du matériau de départ (4).

2. Tranche selon la revendication 1, laquelle comporte sur la surface fendue des structures superficielles, qui par la surface exposée et la géométrie marginale du matériau de départ sont prédéfinissables, de telle sorte que la surface sur la face fendue soit complémentaire de la surface exposée et/ou complémentaire de la géométrie marginale du matériau de départ.

3. Tranche selon la revendication 1 ou 2, les structures superficielles sur la face fendue résultante comportant des motifs sensiblement prédéfinissables sous la forme de lignes de Wallner ouvertes et fermées et les lignes de Wallner fermées correspondant sensiblement à la géométrie marginale du matériau de départ.

4. Tranche selon l'une quelconque des revendications 1 - 3, les structures superficielles sur la face fendue résultante comportant des motifs sensiblement prédéfinissables sous la forme de lignes de Wallner et des lignes en relief s'étendant sensiblement à la transversale de celles-ci.

5. Tranche selon l'une quelconque des revendications 1 - 4, les couches d'application (1), notamment les films de polymère étant préfabriqué(e)s de manière définie en ce qui concerne leurs propriétés physiques et/ou étant trempé(e)s et/ou étant malléabilisé(e)s, notamment concernant différentes épaisseurs de couches, notamment dans l'ordre de 0, 1 - 10 mm, notamment de 0,4 - 1 mm, différentes constantes élastiques et/ou coefficients de dilatation dépendant notamment de la température.

6. Tranche selon l'une quelconque des revendications 1 - 5, les couches d'application (1), notamment les films de polymère (1) étant coupé(s) en relation avec la forme du matériau de départ (4) qui doit être fendu, de telle sorte qu'il soit assuré de ce fait une terminaison marginale exactement définie de la structure composite.

7. Tranche selon l'une quelconque des revendications 1 - 6, deux ou plusieurs couches d'application (1) sur la surface ou sur deux surfaces opposées du matériau de départ, notamment des films de polymère étant fabriqué(e)s indépendamment les un(e)s des autres et indépendamment du matériau de départ (4) qui doit être fendu, étant solidifié(e)s notamment à des températures indépendantes les unes des autres.

8. Tranche selon l'une quelconque des revendications 1 - 7, les couches d'application, notamment les films de polymère (1) comportant une structuration préfabriquée, notamment des profils d'épaisseur variant latéralement et/ou des constantes élastiques variant localement et/ou des coefficients de dilatation thermique variant localement et le polymère étant un polydiorganosiloxane, notamment des polydiméthylsiloxanes (PDMS).

9. Tranche selon l'une quelconque des revendications 1 - 8, le matériau de départ (4) à fendre étant notamment du silicium et/ou du germanium et/ou du saphir et/ou du diamant et/ou du verre et/ou du nitrure et la couche d'application ou le film de polymère étant fabriqué(e) à partir d'une matière bicomposants visco-liquide, notamment du PDMS, laquelle est fabriquée notamment par un procédé de coulée sur une surface plane et une solidification consécutive.

10. Tranche selon l'une quelconque des revendications 1 - 9, la couche d'application préfabriquée, notamment le film de polymère préfabriqué étant fixé(e) solidement sur le matériau de départ (4) à fendre, à l'aide d'un agent adhésif, notamment par déroulage en s'aidant d'un rouleau presseur ou cylindre et une couche d'agent adhésif (2) étant prévue entre le matériau de départ (4) et la couche d'application (1), la couche d'agent adhésif étant prévue notamment sous la forme d'un film de PDMS.

11. Tranche selon l'une quelconque des revendications 1 - 10, le matériau de départ (4) étant conçu en arséniure de gallium.

12. Procédé de fabrication d'une tranche selon l'une quelconque des revendications 1 - 11, notamment de fabrication de fines tranches de silicium et/ou de germanium et/ou de saphir et/ou de diamant et/ou de verre et/ou de nitrure de silicium et/ou d'arséniure de gallium.
